# EUROPEAN PATENT APPLICATION

(11) **EP 4 481 836 A1**
(43) Date of publication of application: **25.12.2024**
(21) Application number: 22927379.2
(22) Date of filing: 28.12.2022
(51) Int. Cl.: H01L 31/107, H01L 27/146

(54) **PHOTODETECTION DEVICE AND MANUFACTURING METHOD FOR SAME**

(30) Priority: 17.02.2022 JP 2022023216
(71) Applicant: Sony Semiconductor Solutions Corporation, Atsugi-shi, Kanagawa 243-0014 (JP)
(72) Inventor: EJIRI, Hirokazu, Atsugi-shi, Kanagawa 243-0014 (JP); KUMAGAI, Hayato, Atsugi-shi, Kanagawa 243-0014 (JP); TSUGAWA, Hidenobu, Atsugi-shi, Kanagawa 243-0014 (JP); NAKAMURA, Ryoichi, Atsugi-shi, Kanagawa 243-0014 (JP); TASHIRO, Yoshiaki, Atsugi-shi, Kanagawa 243-0014 (JP); FUJISAKI, Yutaro, Atsugi-shi, Kanagawa 243-0014 (JP)
(74) Representative: Müller Hoffmann & Partner
(86) International application number: PCT/JP2022/048449
(87) International publication number: WO 2023/157497

(57) **Abstract**

A semiconductor device having high operation reliability is provided. A photodetection device (1) includes a semiconductor substrate (11), a light receiving section (13), a multiplier (14), a first electrode (16), a second electrode (113X), and a resistor (51). The semiconductor substrate (11) has a first surface (1151) and a second surface (11S2) facing each other, and includes a pixel array section (100A) in which a plurality of pixels (P) is disposed in an array in an in-plane direction. The light receiving section (13) is provided inside the semiconductor substrate (11) for each of the pixels (P), and generates carriers according to quantities of received light, by photoelectric conversion. The multiplier (14) provided on the first surface (11S1) of the semiconductor substrate (11) for each of the pixels (P) has a laminated structure of a first conductivity type region (14Y) and a second conductivity type region (14X), and avalanche-multiplies the carriers generated in the light receiving section (13). The first electrode (16) is electrically coupled to the multiplier (14). The second electrode (113X) is electrically coupled to the light receiving section (13). The resistor (51) includes a polycrystalline semiconductor material and provided to be in contact with the first electrode (16), while facing the first surface (11S1).

## Description

### Technical Field

The present disclosure relates to, for example, a photodetection device using an avalanche photodiode (APD), and to a method of manufacturing the photodetection device.

### Background Art

In recent years, a photodetection device having an avalanche photodiode (APD) has been developed. In an APD, a so-called electron avalanche occurs when photons enter. Therefore, a quench resistor for converging the electron avalanche is provided in the APD (See PTL 1, for example).

### Citation List

### Patent Literature

PTL 1: Japanese Unexamined Patent Application Publication No. 2020-150161

### Summary of the Invention

Incidentally, it is desired that such a photodetection device have high operation reliability.

A photodetection device according to one embodiment of the present disclosure includes: a semiconductor substrate, a light receiving section, a multiplier, a first electrode, a second electrode, and a resistor. The semiconductor substrate has a first surface and a second surface facing each other, and includes a pixel array section in which a plurality of pixels is disposed in an array in an in-plane direction. The light receiving section is provided inside the semiconductor substrate for each of the pixels, and generates carriers according to quantities of received light, by photoelectric conversion. The multiplier provided on the first surface of the semiconductor substrate for each of the pixels has a laminated structure of a first conductivity type region and a second conductivity type region, and avalanche-multiplies the carriers generated in the light receiving section. The first electrode is electrically coupled to the multiplier. The second electrode is electrically coupled to the light receiving section. The resistor includes a polycrystalline semiconductor material and provided to be in contact with the first electrode, while facing the first surface.

In the photodetection device according to one embodiment of the present disclosure, the resistor including a polycrystalline semiconductor material is coupled to the first electrode that is electrically coupled to the multiplier. This increases structural stability of the semiconductor substrate as compared to a case in which the resistor includes metal.

### Brief Description of Drawing

[FIG. 1] FIG. 1 is a schematic cross-sectional diagram illustrating a configuration example of a laminated cross section of a photodetection device according to a first embodiment of the present disclosure.
[FIG. 2] FIG. 2 is a block diagram illustrating an example of a schematic configuration of the photodetection device illustrated in FIG. 1.
[FIG. 3A] FIG. 3A is an example of an equivalent circuit diagram of a unit pixel of the photodetection device illustrated in FIG. 1.
[FIG. 3B] FIG. 3B is a waveform chart describing an operation of a pixel circuit illustrated in FIG. 3A.
[FIG. 4A] FIG. 4A is a schematic cross-sectional diagram illustrating a first configuration example of a horizontal cross section of the photodetection device illustrated in FIG. 1.
[FIG. 4B] FIG. 4B is a schematic cross-sectional diagram illustrating a second configuration example of the horizontal cross section of the photodetection device illustrated in FIG. 1.
[FIG. 4C] FIG. 4C is a schematic cross-sectional diagram illustrating a third configuration example of the horizontal cross section of the photodetection device illustrated in FIG. 1.
[FIG. 4D] FIG. 4D is a schematic cross-sectional diagram illustrating a fourth configuration example of the horizontal cross section of the photodetection device illustrated in FIG. 1.
[FIG. 4E] FIG. 4E is a schematic cross-sectional diagram illustrating a fifth configuration example of the horizontal cross section of the photodetection device illustrated in FIG. 1.
[FIG. 4F] FIG. 4F is a schematic cross-sectional diagram illustrating a sixth configuration example of the horizontal cross section of the photodetection device illustrated in FIG. 1.
[FIG. 4G] FIG. 4G is a schematic cross-sectional diagram illustrating a seventh configuration example of the horizontal cross section of the photodetection device illustrated in FIG. 1.
[FIG. 4H] FIG. 4H is a schematic cross-sectional diagram illustrating an eighth configuration example of the horizontal cross section of the photodetection device illustrated in FIG. 1.
[FIG. 5] FIG. 5 is a schematic cross-sectional diagram illustrating a configuration example of a laminated cross section of a photodetection device according to a first modification example of the first embodiment.
[FIG. 6A] FIG. 6A is a schematic cross-sectional diagram illustrating a first configuration example of a horizontal cross section of the photodetection device illustrated in FIG. 5.
[FIG. 6B] FIG. 6B is a schematic cross-sectional diagram illustrating a second configuration example of the horizontal cross section of the photodetection device illustrated in FIG. 5.
[FIG. 6C] FIG. 6C is a schematic cross-sectional diagram illustrating a third configuration example of the horizontal cross section of the photodetection device illustrated in FIG. 5.
[FIG. 7A] FIG. 7A is a schematic cross-sectional diagram illustrating a configuration example of a laminated cross section of a photodetection device according to a second modification example of the first embodiment.
[FIG. 7B] FIG. 7B is a schematic cross-sectional diagram illustrating a configuration example of a horizontal cross section of the photodetection device illustrated in FIG. 7A.
[FIG. 8A] FIG. 8A is a schematic diagram of the laminated cross section, illustrating one process of a method of manufacturing the photodetection device illustrated in FIG. 5.
[FIG. 8B] FIG. 8B is a schematic diagram of the laminated cross section, illustrating one process following FIG. 8A.
[FIG. 8C] FIG. 8C is a schematic diagram of the laminated cross section, illustrating one process following FIG. 8B.
[FIG. 8D] FIG. 8D is a schematic diagram of the laminated cross section, illustrating one process following FIG. 8C.
[FIG. 8E] FIG. 8E is a schematic diagram of the laminated cross section, illustrating one process following FIG. 8D.
[FIG. 8F] FIG. 8F is a schematic diagram of the laminated cross section, illustrating one process following FIG. 8E.
[FIG. 8G] FIG. 8G is a schematic diagram of the laminated cross section, illustrating one process following FIG. 8F.
[FIG. 8H] FIG. 8H is a schematic diagram of the laminated cross section, illustrating one process following FIG. 8G.
[FIG. 8I] FIG. 8I is a schematic diagram of the laminated cross section, illustrating one process following FIG. 8H.
[FIG. 8J] FIG. 8J is a schematic diagram of the laminated cross section, illustrating one process following FIG. 8I.
[FIG. 9] FIG. 9 is a schematic cross-sectional diagram illustrating a configuration example of a laminated cross section of a photodetection device according to a second embodiment of the present disclosure.
[FIG. 10A] FIG. 10A is a schematic cross-sectional diagram illustrating a configuration example of a horizontal cross section of the photodetection device illustrated in FIG. 9.
[FIG. 10B] FIG. 10B is a schematic cross-sectional diagram illustrating a configuration example of the horizontal cross section of the photodetection device illustrated in FIG. 9.
[FIG. 11] FIG. 10B is a schematic cross-sectional diagram illustrating a configuration example of a laminated cross section of a photodetection device according to a first modification example of the second embodiment.
[FIG. 12] FIG. 12 is a schematic cross-sectional diagram illustrating a configuration example of a laminated cross section of a photodetection device according to a second modification example of the second embodiment.
[FIG. 13A] FIG. 13A is a schematic cross-sectional diagram illustrating a configuration example of a laminated cross section of a photodetection device according to a third modification example of the second embodiment.
[FIG. 13B] FIG. 13B is a schematic diagram illustrating a planar configuration example (planar layout) of the photodetection device illustrated in FIG. 13A.
[FIG. 14A] FIG. 14A is a schematic cross-sectional diagram illustrating a configuration example of a laminated cross section of a photodetection device according to a fourth modification example of the second embodiment.
[FIG. 14B] FIG. 14B is a schematic diagram illustrating a planar configuration example (planar layout) of the photodetection device illustrated in FIG. 14A.
[FIG. 15] FIG. 15 is a schematic cross-sectional diagram illustrating a configuration example of a laminated cross section of a photodetection device according to a third embodiment of the present disclosure.
[FIG. 16A] FIG. 16A is a schematic cross-sectional diagram illustrating a first configuration example of a horizontal cross section of the photodetection device illustrated in FIG. 15.
[FIG. 16B] FIG. 16B is a schematic cross-sectional diagram illustrating a second configuration example of the horizontal cross section of the photodetection device illustrated in FIG. 15.
[FIG. 17] FIG. 17 is a schematic cross-sectional diagram illustrating a configuration example of a laminated cross section of a photodetection device according to a first modification example of the third embodiment.
[FIG. 18] FIG. 18 is a schematic cross-sectional diagram illustrating a configuration example of a laminated cross section of a photodetection device according to a fourth embodiment of the present disclosure.
[FIG. 19A] FIG. 19A is a schematic diagram illustrating a first configuration example of a planar configuration example (planar layout) of the photodetection device illustrated in FIG. 18.
[FIG. 19B] FIG. 19B is a schematic diagram illustrating a second configuration example of the planar configuration example (planar layout) of the photodetection device illustrated in FIG. 18.
[FIG. 20] FIG. 20 is an example of an equivalent circuit diagram of a unit pixel of the photodetection device illustrated in FIG. 18.
[FIG. 21A] FIG. 21A is a schematic diagram illustrating a configuration example of a planar configuration example (planar layout) of a photodetection device according to a first modification example of the fourth embodiment.
[FIG. 21B] FIG. 21B is a schematic diagram illustrating a configuration example of a planar configuration example (planar layout) of a photodetection device according to a second modification example of the fourth embodiment.
[FIG. 21C] FIG. 21C is a schematic diagram illustrating a configuration example of a planar configuration example (planar layout) of a photodetection device according to a third modification example of the fourth embodiment.
[FIG. 22] FIG. 22 is a schematic cross-sectional diagram illustrating a configuration example of a laminated cross section of a photodetection device according to a fifth embodiment of the present disclosure.
[FIG. 23] FIG. 23 is an enlarged cross-sectional diagram illustrating an enlarged portion of the photodetection device illustrated in FIG. 22.
[FIG. 24] FIG. 24 is a schematic diagram illustrating a configuration example of a planar configuration example (planar layout) of the photodetection device illustrated in FIG. 22.
[FIG. 25A] FIG. 25A is a schematic diagram of a laminated cross section, illustrating one process of a method of manufacturing the photodetection device illustrated in FIG. 22.
[FIG. 25B] FIG. 25B is a schematic diagram of the laminated cross section, illustrating one process following FIG. 25A.
[FIG. 25C] FIG. 25C is a schematic diagram of the laminated cross section, illustrating one process following FIG. 25B.
[FIG. 25D] FIG. 25D is a schematic diagram of the laminated cross section, illustrating one process following FIG. 25C.
[FIG. 25E] FIG. 25E is a schematic diagram of the laminated cross section, illustrating one process following FIG. 25D.
[FIG. 25F] FIG. 25F is a schematic diagram of the laminated cross section, illustrating one process following FIG. 25E.
[FIG. 25G] FIG. 25G is a schematic diagram of the laminated cross section, illustrating one process following FIG. 25F.
[FIG. 25H] FIG. 25H is a schematic diagram of the laminated cross section, illustrating one process following FIG. 25G.
[FIG. 25I] FIG. 25I is a schematic diagram of the laminated cross section, illustrating one process following FIG. 25H.
[FIG. 26] FIG. 26 is an enlarged cross-sectional diagram illustrating an enlarged portion of a photodetection device according to a first modification example of the fifth embodiment of the present disclosure.
[FIG. 27A] FIG. 27A is a schematic diagram of a laminated cross section, illustrating one process of a method of manufacturing the photodetection device illustrated in FIG. 26.
[FIG. 27B] FIG. 27B is a schematic diagram of the laminated cross section, illustrating one process following FIG. 27A.
[FIG. 27C] FIG. 27C is a schematic diagram of the laminated cross section, illustrating a process following FIG. 27B.
[FIG. 27D] FIG. 27D is a schematic diagram of the laminated cross section, illustrating one process following FIG. 27C.
[FIG. 27E] FIG. 27E is a schematic diagram of the laminated cross section, illustrating one process following FIG. 27D.
[FIG. 27F] FIG. 27F is a schematic diagram of the laminated cross section, illustrating one process following FIG. 27E.
[FIG. 28] FIG. 28 is an enlarged cross-sectional diagram illustrating an enlarged portion of a photodetection device according to a second modification example of the fifth embodiment of the present disclosure.
[FIG. 29] FIG. 29 is an enlarged cross-sectional diagram illustrating an enlarged portion of a photodetection device according to a third modification example of the fifth embodiment of the present disclosure.
[FIG. 30] FIG. 30 is an enlarged cross-sectional diagram illustrating an enlarged portion of a photodetection device according to a fourth modification example of the fifth embodiment of the present disclosure.
[FIG. 31] FIG. 31 is an enlarged cross-sectional diagram illustrating an enlarged portion of a photodetection device according to a fifth modification example of the fifth embodiment of the present disclosure.
[FIG. 32A] FIG. 32A is an enlarged cross-sectional diagram illustrating an enlarged portion of a photodetection device according to a sixth modification example of the fifth embodiment of the present disclosure.
[FIG. 32B] FIG. 32B is an enlarged cross-sectional diagram illustrating an enlarged portion of the photodetection device illustrated in FIG. 32A.
[FIG. 33] FIG. 33 is an enlarged cross-sectional diagram illustrating an enlarged portion of a photodetection device according to a seventh modification example of the fifth embodiment of the present disclosure.
[FIG. 34] FIG. 34 is a functional block diagram illustrating an example of electronic equipment using the photodetection device illustrated in FIG. 1, or the like.
[FIG. 35] FIG. 35 is a block diagram depicting an example of schematic configuration of a vehicle control system.
[FIG. 36] FIG. 36 is a diagram of assistance in explaining an example of installation positions of an outside-vehicle information detecting section and an imaging section.

### Modes for Carrying Out the Invention

In the following, some embodiments of the present disclosure will be described in detail with reference to the drawings. The following description is a specific example of the present disclosure, and the present disclosure is not limited to the following aspects. In addition, the present disclosure is not limited to the arrangement, dimensions, dimension ratios, and the like of components illustrated in each drawing. It is to be noted that the description will be given in the following order.
1. First Embodiment
   (A photodetection device including a resistor including non-metallic electrically conductive material that is electrically coupled to a multiplier with a cathode electrode in between)
   1-0. History
   1.1. Configuration
   1.2. Modification Examples
   1.3. Method of Manufacturing
   1.4. Workings/Effects
2. Second Embodiment
   2-0. History
   2.1. Configuration
   2.2. Workings/Effects
   2.3. Modification Examples
3. Third Embodiment
   3.1. Configuration
   3.2. Workings/Effects
   3.3. Modification Examples
4. Fourth Embodiment
   4-0. History
   4.1. Configuration
   4.2. Workings/Effects
   4.3. Modification Examples
5. Fifth Embodiment
   4-0. History
   4.1. Configuration
   4.2. Workings/Effects
   4.3. Modification Examples
6. Application Examples
7. Applications

### <1. First Embodiment>

### [1-0. History]

There have been proposed techniques related to an APD (avalanche photodiode) applied to LIDAR (Light Detection and Ranging) that is one of remote sensing techniques using light (See Japanese Unexamined Patent Application Publication No. 2020-150161, for example). The LIDAR is a technique that senses a distance to an object by receiving reflected light from light applied to the object, and an apparatus using the technique. The above-described patent literature related to the APD (Japanese Unexamined Patent Application Publication No. 2020-150161) publishes a technique of converging an electron avalanche when photons enter, by a quench resistor, thereby increasing detection sensitivity. The above-described patent literature discloses a structure in which the quench resistor is coupled to a cathode via a metal electrode. Incidentally, in the above technique, a highly concentrated layer is formed through, for example, ion implantation, because a highly concentrated n-type impurity layer is necessary for forming a metal electrode in an Si substrate. However, there is a possibility that ion implantation may cause a crystal fault. In addition, there is another possibility that the SI substrate may be damaged when the metal electrode is formed. Such possibilities become factors that reduce reliability of the APD. Moreover, although in the above-described patent literature, the quench resistor includes a graphene layer, a certain degree of length is necessary to ensure a sufficient resistance value as the quench resistor, which may impede miniaturization. Hence, the present applicant has come to provide the photodetection device with high reliability while coping with downsizing.

### [1-1. Configuration]

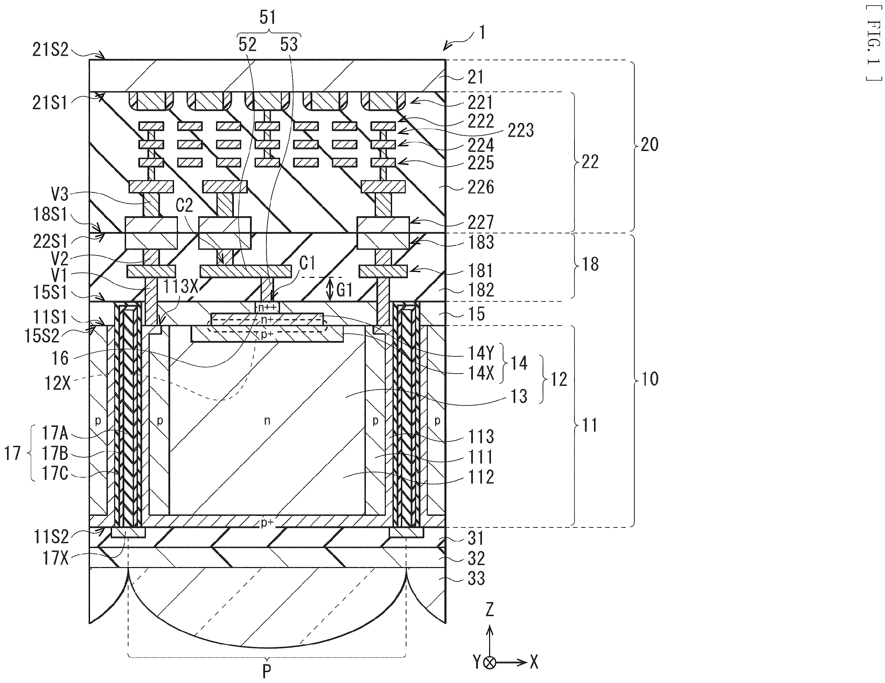

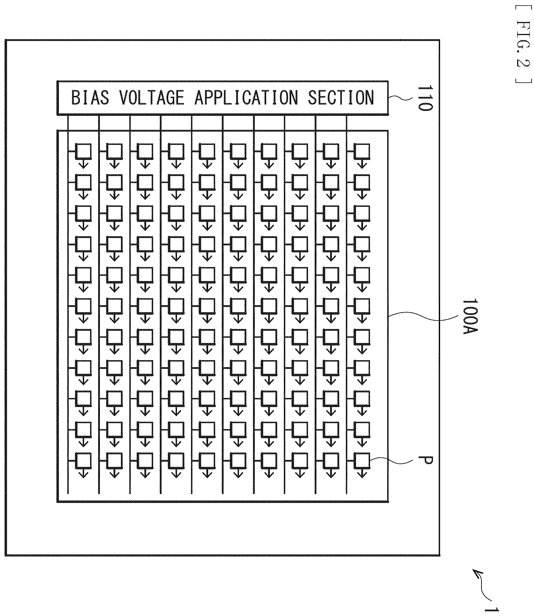

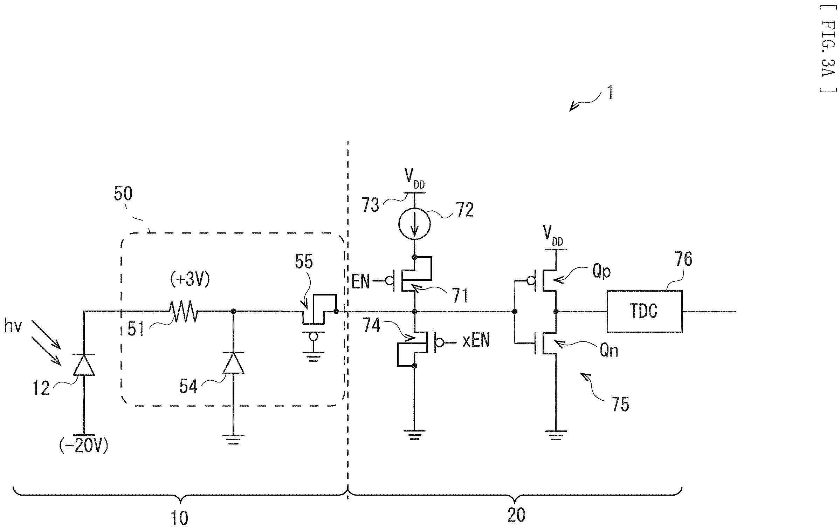

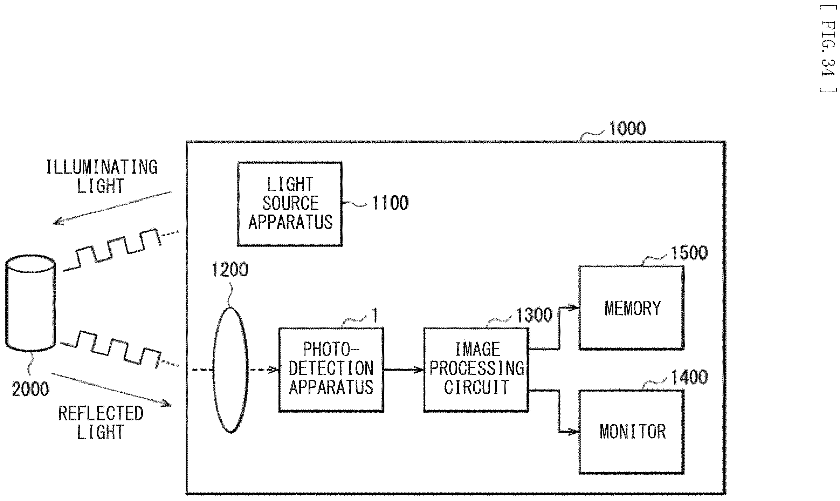

FIG. 1 schematically illustrates an example of a cross-sectional configuration a photodetection device 1 according to a first embodiment of the present disclosure. FIG. 2 is a block diagram illustrating a schematic configuration of the photodetection device 1 illustrated in FIG. 1. FIG. 3A is a circuit diagram illustrating an example of an equivalent circuit of a unit pixel P of the photodetection device 1 illustrated in FIG. 1. The photodetection device 1 may be applied to, for example, a distance imaging sensor (distance imaging apparatus 1000 to be described below. See FIG. 34.) or an image sensor, etc. that perform distance measurement with a ToF (Time-of-Flight) method.

The photodetection device 1 includes, for example, a pixel array section 100A in which a plurality of unit pixels P is disposed in an array in a row direction and in a column direction. As illustrated in FIG. 2, the photodetection device 1 includes a bias voltage application section 110 together with the pixel array section 100A. The bias voltage application section 110 applies a bias voltage to each of the unit pixels P in the pixel array section 100A. In the present embodiment, a description will be given of a case in which electrons are read out as signal charges.

### (Circuit Configuration of Photodetection device 1)

As illustrated in FIG. 3A, the unit pixel P includes a light receiving element 12, a clamping circuit 50 as a protection circuit, a first control transistor 71, a current source 72, a terminal 73, a second control transistor 74, and a readout circuit 75.

The light receiving element 12 converts entering light into an electric signal by photoelectric conversion and outputs the electric signal. Incidentally, the light receiving element 12 converts entering light (photons) into an electric signal by photoelectric conversion and outputs a pulse corresponding to entry of photons. The light receiving element 12 is a SPAD element, for example. The SPAD element has a characteristic that application of a large negative voltage to a cathode forms an avalanche multiplication region (depletion layer) 12X, and electrons generated in response to entry of one photon cause avalanche multiplication, resulting in flow of a large current. An anode of the light receiving element 12 is coupled to the bias voltage application section 110, for example. Specifically, a cathode of the light receiving element 12 is couped to the terminal 73 to which a power supply voltage VDD is given, for example, via the first control transistor 71 and the current source 72. For example, a voltage of approximately 3V is given as the power supply voltage VDD. The cathode of the light receiving element 12 is coupled to a source terminal of the first control transistor 71. A device voltage VB is applied from a device voltage application section to the anode of the light receiving element 12. The large negative voltage that causes the avalanche multiplication, that is, a voltage (such as approximately -20V) equal to or larger than a breakdown voltage is applied as the device voltage VB.

The first control transistor 71 includes a p-type MOSFET (Metal-Oxide-Semiconductor Field-Effect Transistor) and is also referred to as a quenching resistor element. The first control transistor 71 is coupled in series with the light receiving element 12 via the clamping circuit 50. The source terminal of the first control transistor 71 is coupled to the cathode of the light receiving element 12, and a drain terminal of the first control transistor 71 is coupled to the terminal 73 via the current source 72. The first control transistor 71 enters a conductive state by an enable signal EN applied to a gate electrode becoming low level and allows a current from the current source 72 to flow to the light receiving element 12. The second control transistor 74 is coupled between the cathode of the light receiving element 12 and a reference potential node (ground, for example). The second control transistor 74 includes an N-type MOS transistor, for example. The second control transistor 74 enters a conductive state by a signal xEN having a reverse phase to the enable signal EN being applied to the gate electrode, thereby reducing the voltage applied to the light receiving element 12 to the breakdown voltage or lower, and causing the light receiving element 12 to be in inactivated state.

The readout circuit 75 is, for example, a CMOS inverter circuit including a P-type MOS transistor Qp and an N-type MOS transistor Qn. The readout circuit 75 includes an input terminal coupled to the cathode of the light receiving element 12, the source terminal of the first control transistor 71, and the second control transistor 74, and an output terminal coupled to an arithmetic processor 76 to be described below. The readout circuit 75 outputs a light reception signal on the basis of a carrier (signal charge) multiplied by the light receiving element 12. More specifically, the readout circuit 75 shapes a voltage generated from the electrons multiplied by the light receiving element 12. The readout circuit 75 outputs, to the arithmetic processor 76, a light reception signal that generates a pulse waveform, for example, with arrival time of one photon as a starting point. For example, the arithmetic processor 76 performs arithmetic processing to determine a distance to a subject on the basis of timing when a pulse indicating the arrival time of photon is generated in each light reception signal, and determines the distance for each unit pixel P. On the basis of those distances, a distance image is generated in which distances to the subject detected by the plurality of unit pixels P are arranged in a plane.

The clamping circuit 50 is a protection circuit provided between the light receiving element 12 and an input end of the readout circuit 75. The clamping circuit 50 is an overvoltage protection circuit for protecting the P-type MOS transistor Qp and the N-type MOS transistor Qn that constitute the readout circuit 75 as well as the first control transistor 71 or the second control transistor 74, from an overvoltage that occurs when the light receiving element 12 is irradiated with laser beams with large quantities, for example.

In this manner, provision of the clamping circuit 50 between the light receiving element 12 and the input end of the readout circuit 75 makes it possible to protect the readout circuit 75, or the like, from the overvoltage in a case where the light receiving element 12 is irradiated with laser beams with light quantities equal to or larger than predetermined light quantities (equal to or larger than expected).

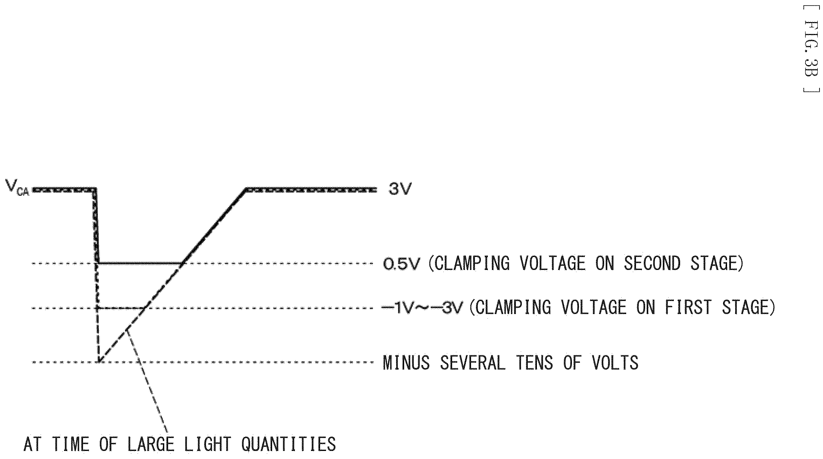

Specifically, as illustrated in FIG. 3, the clamping circuit 50 includes, for example, a resistor element 51, a first clamping element 54, and a second clamping element 55. One end of the resistor element 51 is coupled to a cathode electrode of the light receiving element 12. The first camping element 54 includes, for example, a clamping diode that has a cathode coupled to another end (output end) of the resistor element 51 and an anode coupled to the reference potential node (ground, for example).

The resistor element 51 is provided to limit a value of a current flowing through the first clamping element 54 from exceeding a rated forward current of the current when an overvoltage occurs in the light receiving element 12. The clamping diode that is the first clamping element 54 clamps an overvoltage to a certain voltage (forward voltage VF) when the overvoltage exceeding a clamping voltage occurs in the light receiving element 12.

It is to be noted that the first clamping element 54 is not limited to the clamping diode. For example, in addition to the clamping diode, it is possible to use a Schottky barrier diode, or the like, as the first clamping element 54.

The second clamping element 55 includes, for example, the P-type MOS transistor. The second clamping element 55 is coupled between a first clamping element 72 (such as an anode of the clamp diode) and the node N to which the input end of the readout circuit 75 is coupled. The P-type MOS transistor, as the second clamping element 55, has the gate electrode coupled to the reference potential node (such as the ground) and a back gate coupled to a source electrode.

Here, as an example, a description is given of a clamping operation in a case where an overvoltage of minus several tens of volts occurs in the light receiving element 12, using the waveform diagram of FIG. 3B. As mentioned earlier, the clamping diode as the first clamping element 54 clamps the overvoltage that occurs in the light receiving element 12 to the certain voltage (forward voltage VF). This clamping operation clamps the overvoltage that occurs in the light receiving element 12 to a negative voltage of, for example, about -1V to -3V.

Here, due to a negative voltage generated by the clamping operation of the first clamping element 54, the negative voltage may exceed a withstand voltage of a MOS transistor to be described below. The second clamping element 55 is provided to address this negative voltage problem. That is, the second clamping element 55 clamps a voltage of the node N to which the input end of the readout circuit 75 is coupled to a gate-source voltage Vgs (such as about 0.5V) of the P-type MOS transistor As a result, the clamping operation by the first clamping element 54 makes it possible to solve the problem of the negative voltage.

### (Structure of Photodetection device 1)

The photodetection device 1 is a so-called back-illuminated photodetection device. As illustrated in FIG. 1, in the photodetection device 1, for example, a logic substrate 20 is laminated on a front side of a sensor substrate 10 (for example, a first surface 11S1 that is a front side of a semiconductor substrate 11 constituting the sensor substrate 10), so as to receive light from a back side of the sensor substrate 10 (a second surface 11S2 that is a back side of the semiconductor substrate 11 constituting the sensor substrate 10). The photodetection device 1 has the light receiving element 12 for each unit pixel P. The light receiving element 12 includes the light receiving section 13 and the multiplier 14, and the light receiving section 13 is formed by being embedded in the semiconductor substrate 11. Further, in the semiconductor substrate 11, a p-type semiconductor region (p+) 14X is formed on the first surface 11S1, the p-type semiconductor region (p+) 14X and an n-type semiconductor region (n+) 14Y constituting the multiplier 14. A semiconductor layer 15 is provided on side of the first surface 11S1 of the semiconductor substrate 11. The n-type semiconductor region (n+) 14Y that constitutes the multiplier 14 is provided on the semiconductor layer 15.

It is to be noted symbols "p" and "n" in the figures represent a p-type semiconductor region and an n-type semiconductor region, respectively. Furthermore, "+" or "-" at the end of "p" both represent impurity concentration in the p-type semiconductor region. Similarly, "+" or "-" at the end of "n" both represent impurity concentration in the n-type semiconductor region. Here, a larger number of "+" indicates that the impurity concentration is higher, and a larger number of "-" indicates that the impurity concentration is lower. This also applies to subsequent drawings.

The sensor substrate 10 includes, for example, the semiconductor substrate 11 including a silicon substrate, the semiconductor layer 15, and a multilayer wiring layer 18. The semiconductor substrate 11 has the first surface 11S1 and the second surface 11S2 that face each other. The semiconductor substrate 11 has a p-well (p) 111 common to the plurality of unit pixels P. On the semiconductor substrate 11 is provided an n-type semiconductor region (n) 112 the impurity concentration of which is controlled to be an n-type, for example. As a result, the light receiving element 12 is formed for each of the unit pixels. On the semiconductor substrate 11 is further provided a pixel separator 17 extending from the first surface 1S1 to the second surface 11S2.

The light receiving element 12 has a multiplication region, that is, an avalanche multiplication region, where carriers are avalanche-multiplied by a high electric field region. As described above, the light receiving element 12 is the SPAD element that makes it possible to form the avalanche multiplication region (depletion layer) by applying a large positive voltage to the cathode and to avalanche-multiply electrons generated in response to entry of one photon.

The light receiving element 12 includes the light receiving section 13 and the multiplier 14.

The light receiving section 13 performs photoelectric conversion that absorbs light entering from side of the second surface 11S2 of the semiconductor substrate 11 and generates carriers according to the quantities of received light. As described above, the light receiving section 13 includes the n-type semiconductor region (n) 112 the impurity concentration of which is controlled to be the n-type. The carriers (electrons) generated in the light receiving section 13 are transferred to the multiplier 14 due to a potential gradient. It is to be noted that the light receiving section 13 is a specific example corresponding to the "light receiving section" of the present disclosure.

The multiplier 14 avalanche-multiplies the carriers (here, electrons) generated in the light receiving section 13. The multiplier 14 includes, for example, the p-type semiconductor region (p+) 14X having the higher impurity concentration than the p-well (p) 111 and the n-type semiconductor region (n+) 14Y having the higher impurity concentration than the n-type semiconductor region (n) 112. The p-type semiconductor region (p+) 14X is provided to face the first surface 11S1 in the semiconductor substrate 11. The n-type semiconductor region (n+) 14Y is provided to protrude from the first surface 11S1 of the semiconductor substrate 11. Specifically, as described above, the n-type semiconductor region (n+) 14Y is formed by being embedded in the semiconductor layer 15 provided on the first surface of the semiconductor substrate 11, facing a second surface 15S2 of the semiconductor layer 15. It is to be noted that the multiplier 14 is a specific example corresponding to the "multiplier" of the present disclosure.

In the light receiving element 12, an avalanche multiplication region 12X is formed in a junction region of the p-type semiconductor region (p+) 14X provided to face the first surface 11S1 of the semiconductor substrate 11 and the n-type semiconductor region (n+) 14Y provided to face the second surface 15S2 of the semiconductor layer 15. The avalanche multiplication region 12X is a high electric field region, that is, a depletion layer, formed by a large negative voltage applied to the anode. The avalanche multiplication region 12X is formed at a boundary surface between the p-type semiconductor region (p+) 14X and the n-type semiconductor region (n+) 14Y. In the avalanche multiplication region 12X, electrons (e-) generated by one photon entering the light receiving element 12 are multiplied.

The semiconductor layer 15 is a semiconductor layer including, for example, silicon, and formed on the first surface 11S1 of the semiconductor substrate 11 by using, for example, an epitaxial crystal growth method. The semiconductor layer 15 corresponds to a specific example of the "semiconductor layer" of the present disclosure. The semiconductor layer 15 has a first surface 15S1 and the second surface 15S2 that face each other. The first surface 15S1 faces the multilayer wiring layer 18, and the second surface 15S2 faces the semiconductor substrate 11. As described above, the n-type semiconductor region (n+) 14Y is formed by being embedded in the semiconductor layer, facing the second surface 15S2.

In the semiconductor layer 15, a contact electrode 16 is further provided on the n-type semiconductor region (n+) 14Y, facing the first surface 15S1. The contract electrode 16 is a cathode as a specific example corresponding to the "first electrode" of the present disclosure, and is electrically coupled to the multiplier 14. The contact electrode 16 includes, for example, an n-type semiconductor region (n++) having the higher impurity concentration than the n-type semiconductor region (n+) 14Y.

The pixel separator 17 electrically separates adjacent unit pixels P and is provided in a grid in the pixel array section 100A so as to surround each of the plurality of unit pixels P, for example, in a planar view. The pixel separator 17 extends from the second surface 11S2 of the semiconductor substrate 1 1 to the first surface 15S1 of the semiconductor layer 15. That is, the pixel separator 17 penetrates the semiconductor substrate 11 and the semiconductor layer 15. The pixel separator 17 is formed by using insulating films 17B and 17C such as a silicon oxide (SiOx) film, and a light shielding film 17A.

A p-type semiconductor region (p+) 113 having the higher impurity concentration than the p-well 111 is provided around the pixel separator 17. The p-type semiconductor region (p+) 113 includes an expanded portion 113X expanded toward inside of the unit pixel P adjacent to the first surface 11S1 of the semiconductor substrate 11 (See FIG. 1). The expanded portion 113X is an anode as a specific example corresponding to the "second electrode" of the present disclosure, and also serves as a contact electrode electrically coupling to the light receiving section 13. The p-type semiconductor region (p+)113 further extends along the second surface 11S2 of the semiconductor substrate 11.

The semiconductor layer 15 and the multilayer wiring layer 18 are laminated in order on the first surface 11S1 opposite to the second surface 11S2 that is a light entering surface of the semiconductor substrate 11. In the multilayer wiring layer 18, a wiring layer 181 including one or more wiring lines is embedded in an inter-layer insulating layer 182. The wiring layer 181 is, for example, a path that supplies a voltage to be applied to the semiconductor substrate 11 or the light receiving element 12 or that takes out the carriers generated in the light receiving element 12. Some wiring lines of the wiring layer 181 are electrically coupled to the contact electrode 16 or the expanded portion 113X via vias V1. A plurality of pad electrodes 183 is embedded adjacent to a surface of the inter-layer insulating layer 182 (surface 18S1 of the multilayer wiring layer 18) on side opposite to the semiconductor substrate 11 side. The plurality of pad electrodes 183 is electrically coupled to some wiring lines of the wiring layer 181 via vias V2. It is to be noted that although FIG. 1 illustrates an example in which the one wiring layer 181 is formed in the multilayer wiring layer 18, the number of layers of the wiring layer 181 to be embedded in the multilayer wiring layer 18 is not limited and two or more wiring layers may be formed.

The inter-layer insulating layer 182 includes, for example, a single-layer film including one kind of silicon oxide (SiOx), TEOS, silicon nitride (SiNx), and silicon oxynitride (SiOxNy), etc., or a laminated film including two or more kinds of silicon oxide (SiOx), TEOS, silicon nitride (SiNx), and silicon oxynitride (SiOxNy), etc.

The wiring layer 181 is formed using, for example, aluminum (Al), copper (Cu), or tungsten (W), or the like.

The pad electrodes 183 are exposed on the surface 18S1 of the multilayer wiring layer 18 that is a bonded surface with the logic substrate 20. The pad electrodes 183 is used, for example, for coupling to the logic substrate 20. The pad electrode 183 is formed, using copper (Cu), for example.

The resistor element 51 is further provided in the inter-layer insulating layer 182. The resistor element 51 is electrically coupled to the contact layer 16, and is a resistor including a polycrystalline semiconductor material such as polysilicon (Poly-Si) including, for example, an n-type impurity element. The resistor element 51 includes, for example, a main body section 52 and a take-out section 53, the main body section 52 extending parallel to the first surface 11S1, that is, extending along an XY plane, and the take-out section 53 connecting the main body section 52 and the contact layer 16. In the example of a structure illustrated in FIG. 1, the main body section 52 is formed at a same level as the wiring layer 181. However, the main body section 52 of the resistor element 51 may be provided at a level different from the wiring layer 181. Here, it is desirable that a distance between a lower surface of the main body section 52 and an upper surface of the contact layer 16, that is, a thickness G1 (See FIG. 1) of a portion of the inter-layer insulating layer 182 sandwiched between the main body section 52 and the contact layer 16, be larger than 150nm when relative permittivity ε of a material constituting the inter-layer insulating layer 182 is 4.2. This is because in a case where the thickness G1 is smaller than this, there is a possibility that a strong electric field may be generated in an unintended location between the main body section 52 and the multiplier 14, that is, a location other than a first coupling section C1, resulting in unintended avalanche multiplication of electrons. In addition, the via V2 is provided to stand on an upper surface of the main body section 52. That is, the resistor element 51 is electrically coupled to the pad electrodes 183 via the via V2. However, for example, another wiring layer such as the wiring layer 181 may be provided between the main body section 52 and the via V2. It is to be noted that the via V2 coupled to the resistor element 51 is a specific example corresponding to the "first wiring line" of the present disclosure.

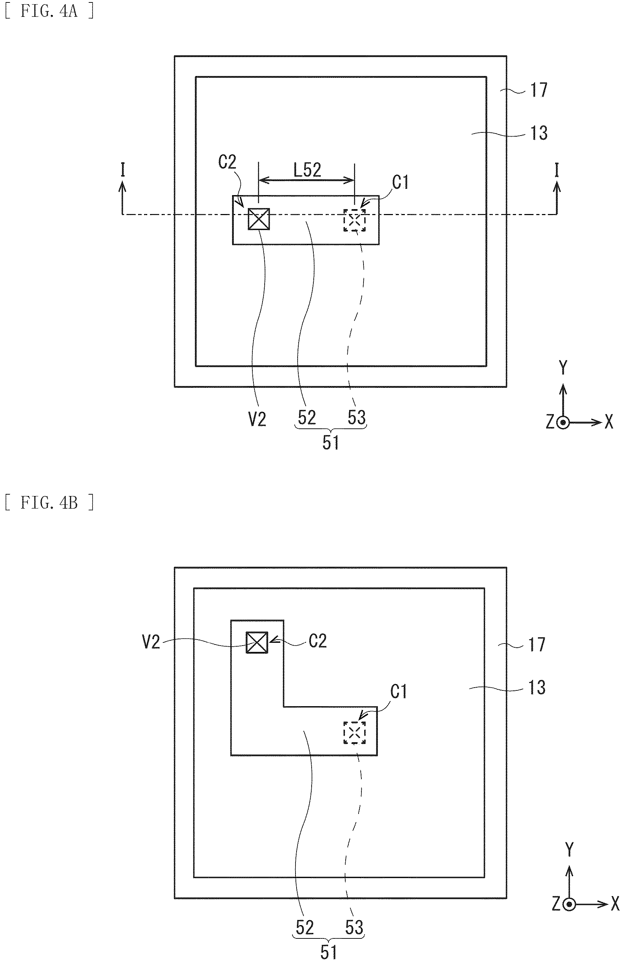

Additionally, in the present disclosure, as illustrated in FIG. 1 and FIG. 4A, a position in the XY plane of the first coupling section C1 between the take-out section 53 of the resistor element 51 and the contact layer 16 and a position in the XY plane of a second coupling section C2 between the main body section 52 of the resistor element 51 and the via V2 may be different from each other. That is, the take-out section 53 and the via V2 may be disposed so as not to overlap each other in a lamination direction (Z-axis direction) that is orthogonal to the first surface 11S1. This is because a resistance value of the resistor element 51, that is, a resistance value between the contact layer 16 and the via V2, increases in proportion to a path length L52.

It is to be noted that FIG. 4A is a schematic cross-sectional diagram illustrating a first configuration example (planar layout) of an XY cross section of the photodetection device 1.

As illustrated in FIG. 1 and FIG. 4A, the first coupling section C1 is located, for example, in a middle region of a pixel P in the XY plane, and the second coupling section C2 is located in a peripheral region of the pixel P in the XY plane.

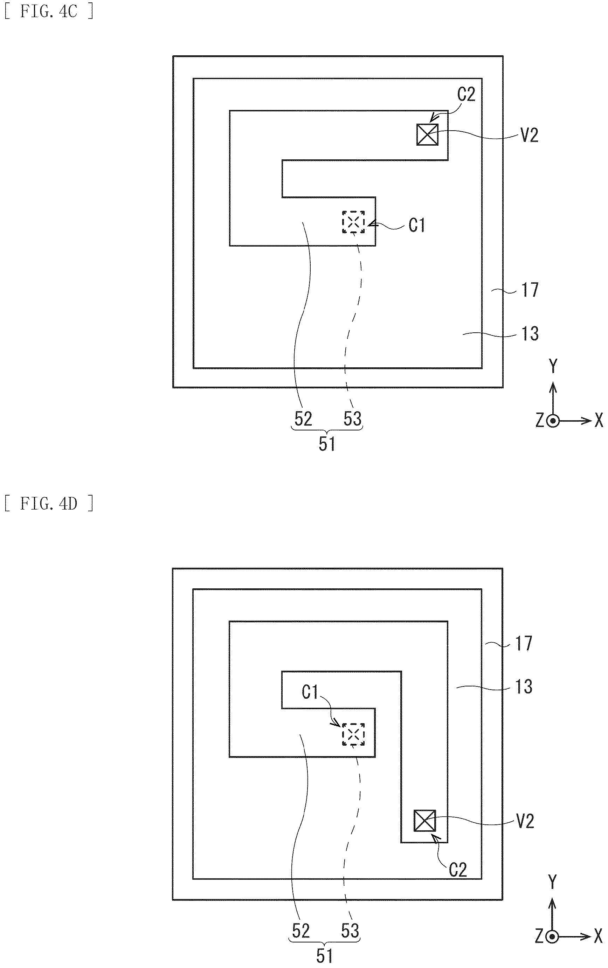

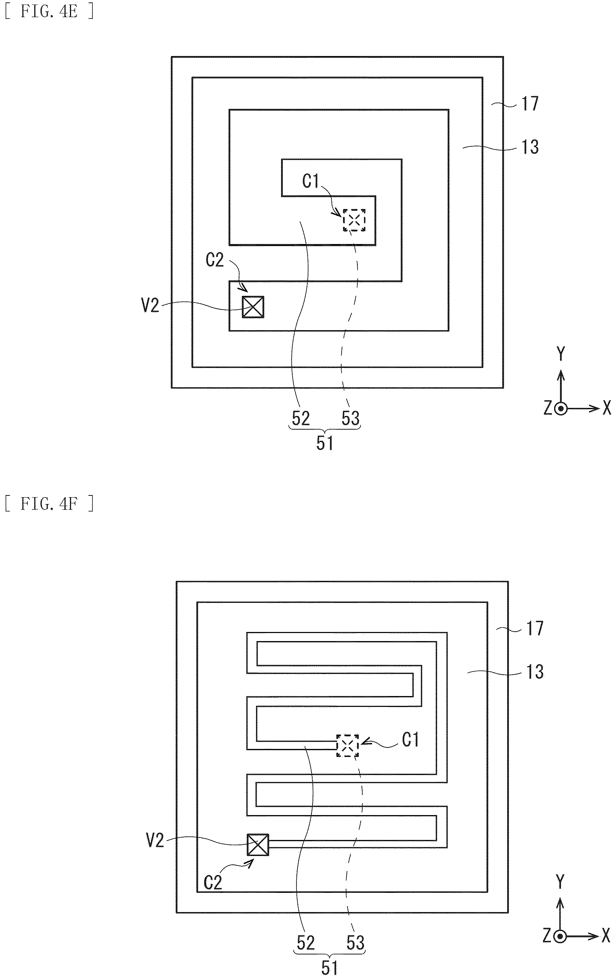

It is to be noted in the first configuration example illustrated in FIG. 4A, the main body section 52 extends linearly in the XY plane, but the present disclosure is not limited to this. As with in second to fifth configurations of the XY cross section of the photodetection device 1 illustrated in FIG. 4B to FIG. 4E, for example, the main body section 52 may extend so that a traveling direction varies at least one or more locations from the middle region of the pixel P toward the peripheral region of the pixel P in the XY plane. In the second configuration example of FIG. 4B, the main body section 52 includes one bent portion at one location on a path from the first coupling section C1 to the second coupling section C2. In the third configuration example of FIG. 4C, the main body section 52 includes two bent portions on the path from the first coupling section C1 to the second coupling section C2. In the fourth configuration example of FIG. 4D, the main body section 52 includes three bent portions on the path from the first coupling section C1 to the second coupling section C2. Furthermore, in the fifth configuration example of FIG. 4E, the main body section 52 extends spirally from the middle region of the pixel P to the peripheral region of the pixel P in the XY plane. It is to be noted that although in FIG. 4E, the main body section 52 has a shape to go around approximately once only, the main body section 52 may have a spiral shape in which the main body section 52 goes around a plurality of times.

It is to be noted that FIG. 4B to FIG. 4E are schematic cross-sectional diagrams illustrating the second to fifth configuration example of the XY cross section of the photodetection device 1.

In addition, in the present disclosure, the shape of the main body section 52 in the XY plane is not limited to a spiral shape, and as illustrated in FIG. 4F, for example, a zigzag portion may be included. Furthermore, as illustrated in FIG. 4F, a width of the main body section 52 may be smaller than dimensions of the take-out section 53 in the XY plane or dimensions of the via V2 in the XY plane.

It is to be noted that FIG. 4F is a schematic cross-sectional diagram illustrating a sixth configuration example of the XY cross section of the photodetection device 1.

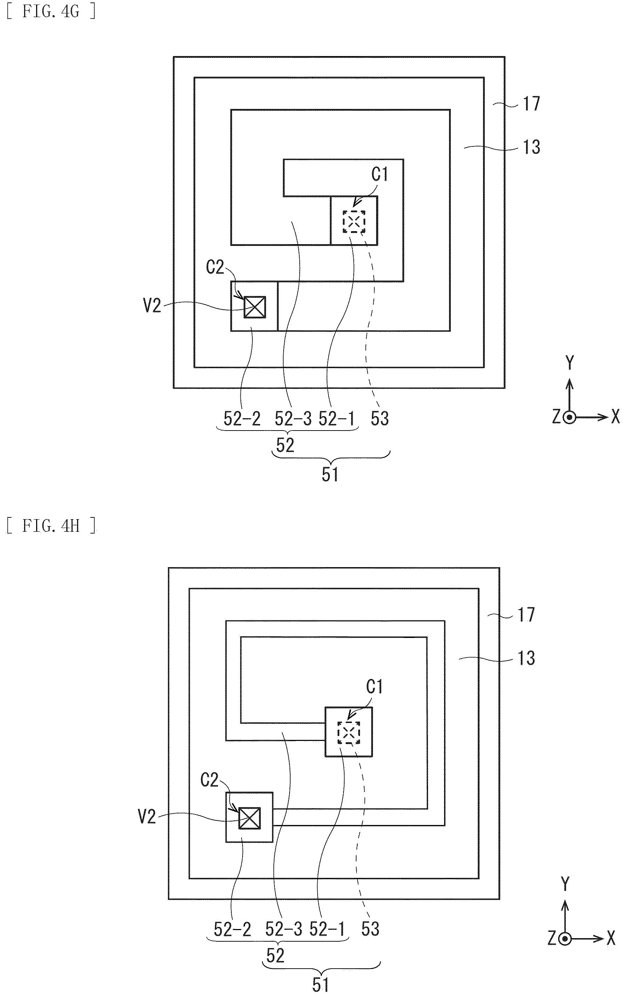

In addition, in the present disclosure, as in a seventh configuration example of the XY cross section of the photodetection device 1 illustrated in FIG. 4G, for example, the main body section 52 may include first to third portions 52-1 to 52-3, each having a volume resistivity that differs from each other. The first portion 52-1 is a portion of the main body section 52 to be coupled to the take-out section 53, the second portion 52-2 is a portion of the main body section 52 to be coupled to the via V2, and the third portion 52-3 is a middle portion of the main body section 52 in a longitudinal direction, coupling the first portion 52-1 and the second portion 52-2. In the seventh configuration example of FIG. 4G, for example, the third portion 52-3 may have the highest volume resistivity, and the first portion 52-1 and the second portion 52-2 may have the volume resistivity lower than the third portion 52-3. In that case, for example, by causing the third portion 52-3 to have an n-type impurity concentration lower than the n-type impurity concentration of the first portion 52-1 and the second portion 52-2, high resistance of the third portion 52-3 may be achieved. Alternatively, by adding a p-type impurity only to the third portion 52-3 by ion implantation, or the like, to reduce the effective n-type impurity concentration in the third portion 52-3, the high resistance of the third portion 52-3 may be achieved. Or, by adding at least one of O (oxygen), N (nitrogen) or both to the third portion 52-3 and performing heat treatment, the high resistance of the third portion 52-3 may be achieved. Furthermore, by ion-implanting Si (silicon) or Ar (argon), or the like, to the third portion 52-3 to break crystals of a polycrystalline semiconductor such as polysilicon, the high resistance of the third portion 52-3 may be achieved.

In addition, in the present disclosure, in an eighth configuration example of the XY cross section of the photodetection device 1 as illustrated in FIG. 4H, for example, by making a width of the third portion 52-3 of the main body section 52 narrower than a width of the first portion 52-1 and a width of the second portion 52-2, the high resistance of the third portion 52-3 may be achieved.

The logic substrate 20 includes, for example, a semiconductor substrate 21 including a silicon substrate, and a multilayer wiring layer 22. The logic substrate 20 includes, for example, the bias voltage application section 110 described above, a readout circuit that outputs a pixel signal based on electric charges outputted from or the unit pixel P of the pixel array section 100A, or a logic circuit including a vertical driving circuit, a horizontal driving circuit, and an output circuit, or the like. It is to be noted that the logic circuit may include a column signal processing circuit.

In the multilayer wiring layer 22, for example, a gate wiring line 221 of a transistor that constitutes the readout circuit, and wiring layers 222, 223, 224, and 225 including a one or more wiring lines are laminated in order from side of the semiconductor substrate 21. An inter-layer insulating layer 226 is provided in a gap between the gate wiring line 221 of the transistor and the wiring layers 222, 223, 224, and 225 including the one or more wiring lines. A plurality of pad electrodes 227 is embedded in a surface 22S1 of the multilayer wiring layer 22, the surface 22S1 being a surface of the inter-layer insulating layer 226 on side opposite to the semiconductor substrate 21 side. The plurality of pad electrodes 227 is electrically coupled to some wiring lines of the wiring layer 225 via a via V3.

Similarly to the inter-layer insulating layer 182, the inter-layer insulating layer 117 includes , for example, a single-layer film including one kind of silicon oxide (SiOx), TEOS, silicon nitride (SiNx), and silicon oxynitride (SiOxNy), etc. or a laminated film including two or more kinds of these single-layer films.

Similarly to the wiring layer 181, the gate wiring line 221 and the wiring layers 222, 223, 224, and 225 are formed using, for example, aluminum (Al), copper (Cu), or tungsten (W), or the like.

The pad electrodes 227 are exposed on the surface 22S1 of the multilayer wiring layer 22 that is a bonded surface with the sensor substrate 10, and is coupled to, for example, the pad electrode 183 of the sensor substrate 10. Similarly to the pad electrode 183, the pad electrode 227 is formed using, for example, copper (Cu).

In the photodetection device 1, for example, CuCu bonding is done between the pad electrode 183 and the pad electrode 227. This electrically couples the cathode of the light receiving element 12 to a quenching resistor element 120 provided on side of the logic substrate 20, and electrically couples the anode of the light receiving element 12 to the bias voltage application section 110.

On the second surface 11S2 that is the light entering surface of the semiconductor substrate 11 is provided a microlens 33 via, for example, a passivation film 31 and a color filter 32, for each unit pixel P, for example.

The microlens 33 condenses light entering from above the microlens 33 onto the light receiving element 12, and is formed using, for example, silicon oxide (SiOx), or the like.

### [1-2. Modification Examples]

### (First Modification Example)

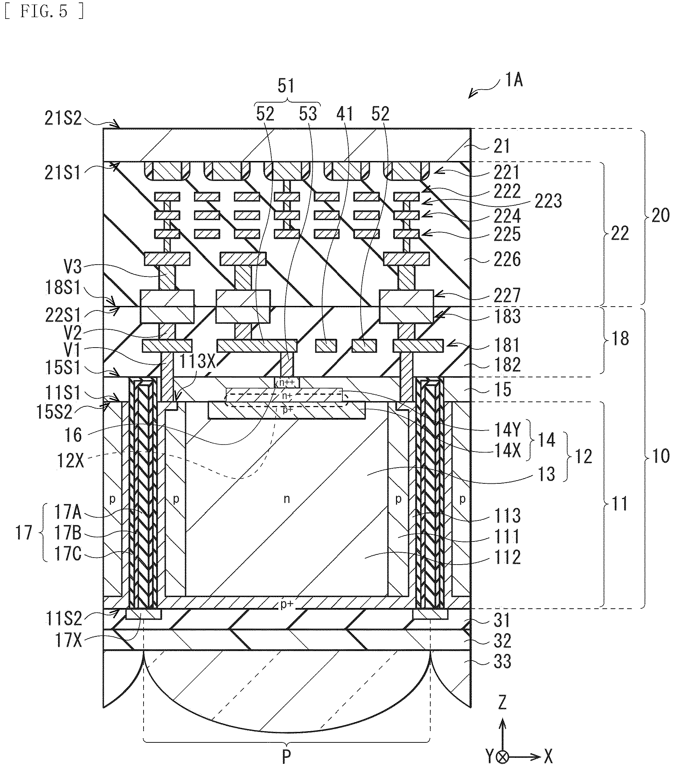

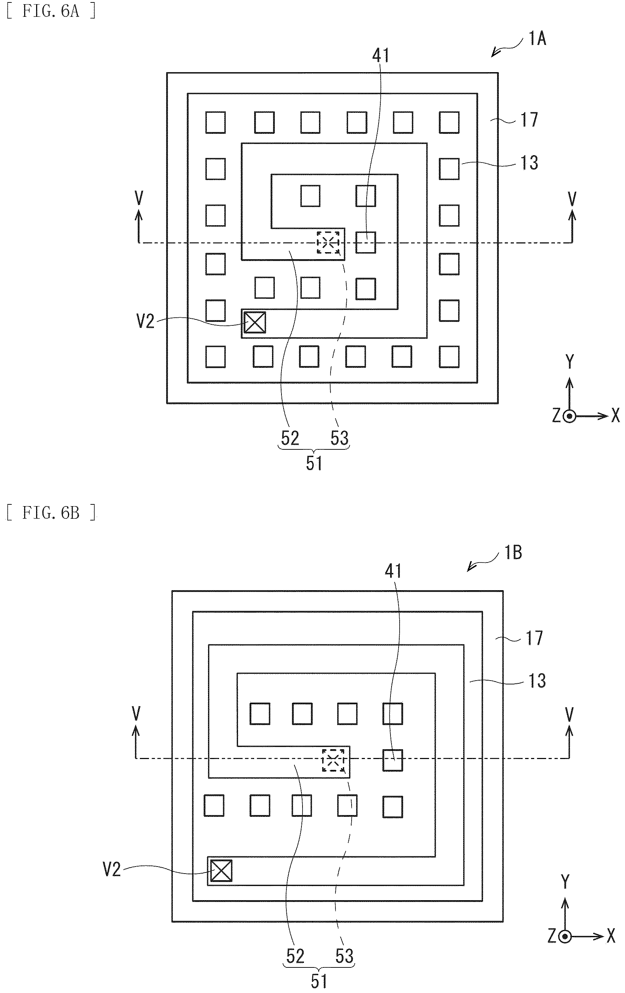

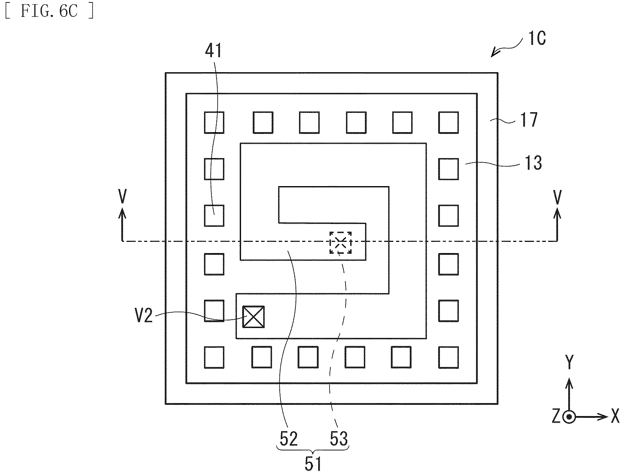

FIG. 5 schematically illustrates an example of a laminated cross-sectional configuration of a photodetection device 1A as a first modification example according to the first embodiment of the present disclosure. FIG. 6A to FIG. 6C are schematic cross-sectional diagrams illustrating a first to third configuration examples (planar layouts) of the XY cross section of the photodetection device 1A illustrated in FIG. 5, respectively.

As illustrated in FIG. 5 and FIG. 6A to FIG. 6C, the photodetection device 1A further includes a reflection layer 41. A configuration of the photodetection device 1A is substantially same as the configuration of the photodetection device 1, except that the photodetection device 1A further includes the reflection layer 41. A plurality of the reflection layers 41 is disposed discretely, for example, at a same level as the main body section 52, and around the main body section 52, along the XY plane. It is possible to form the reflection layer 41 using a wiring line material having light reflectivity, such as aluminum (Al). In addition, it is possible to form the reflection layer 41, using a non-metallic material such as silicon oxide. Alternatively, the reflection layer 41 may include a same kind of material as the polycrystalline semiconductor material that constitutes the main body section 52.

In this manner, the reflection layer 41 is provided in the photodetection device 1A of this modification example. As a result, light that passes through the light receiving section 13 without being absorbed is reflected by the reflection layer 41 and re-enters the light receiving section 13. Therefore, it becomes possible to improve sensitivity to entering light as compared to the photodetection device 1 with no reflection layer 41.

### (Second Modification Example)

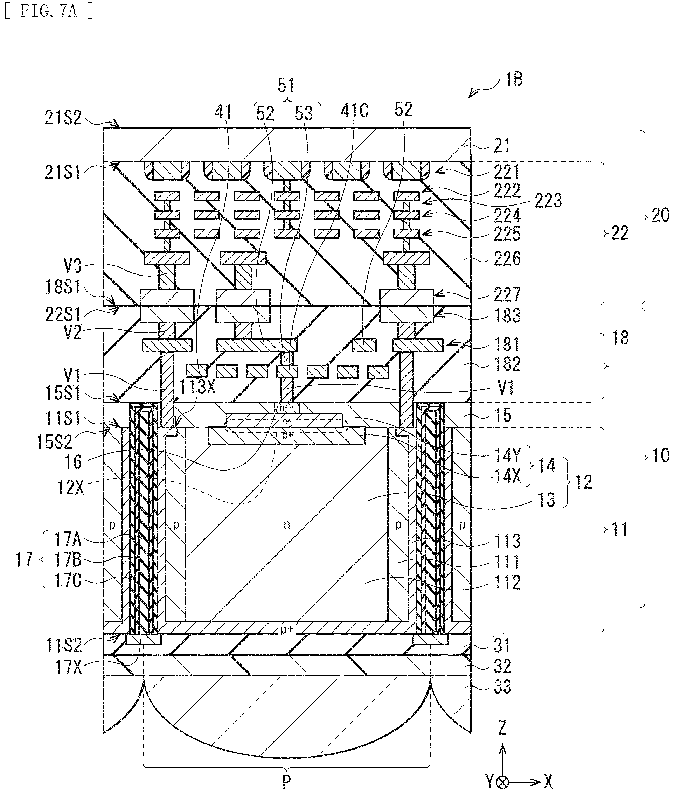

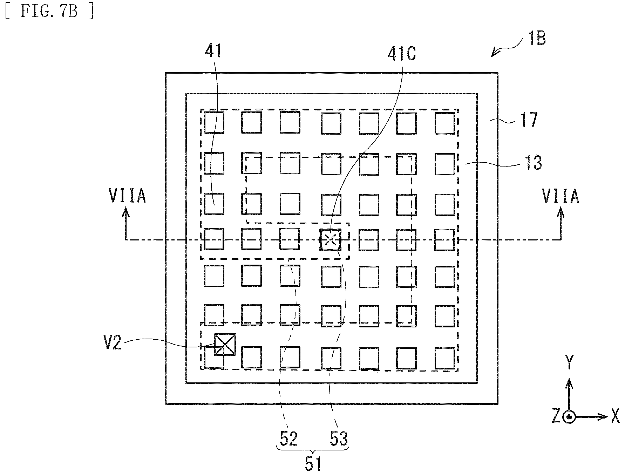

FIG. 7A schematically illustrates an example of a laminated cross-sectional configuration of a photodetection device 1B as a second modification example of the first embodiment of the present disclosure. FIG. 7B is a schematic cross-sectional diagram illustrating a configuration example (planar layout) of an XY cross section of the photodetection device 1B illustrated in FIG. 7A.

Similarly to the photodetection device 1A, the photodetection device 1B further includes a plurality of the reflection layers 41, as illustrated in FIG. 7A and FIG. 7B. The plurality of reflection layers 41 is disposed discretely along the XY plane. However, in the photodetection device 1B, the plurality of reflection layers 41 is further provided at a level between a level on which the main body section 52 is provided and a level on which the contact layer 16 is provided. Here, the main body section 52 overlaps one reflection layer 41C of the plurality of reflection layers 41 in a thickness direction (Z-axis direction). The reflection layer 41C may electrically couple the main body section 52 and the contact layer 16. The reflection layer 41C is coupled to the main body section 52 via the take-out section 53 and coupled to the contact layer 16 via the via V2. It is possible to form the reflection layer 41 using, for example, the wiring line material having the light reflectivity, such as aluminum (Al). It is also possible to form the reflection layer 41 using a non-metallic material such as silicon oxide. Alternatively, the reflection layer 41 may include a polycrystalline semiconductor material that is of the same type as the polycrystalline semiconductor material that constitutes the main body section 52, or may include a different kind of a polycrystalline semiconductor material from the polycrystalline semiconductor material that constitutes the main body section 52.

### [1-3. Method of Manufacturing]

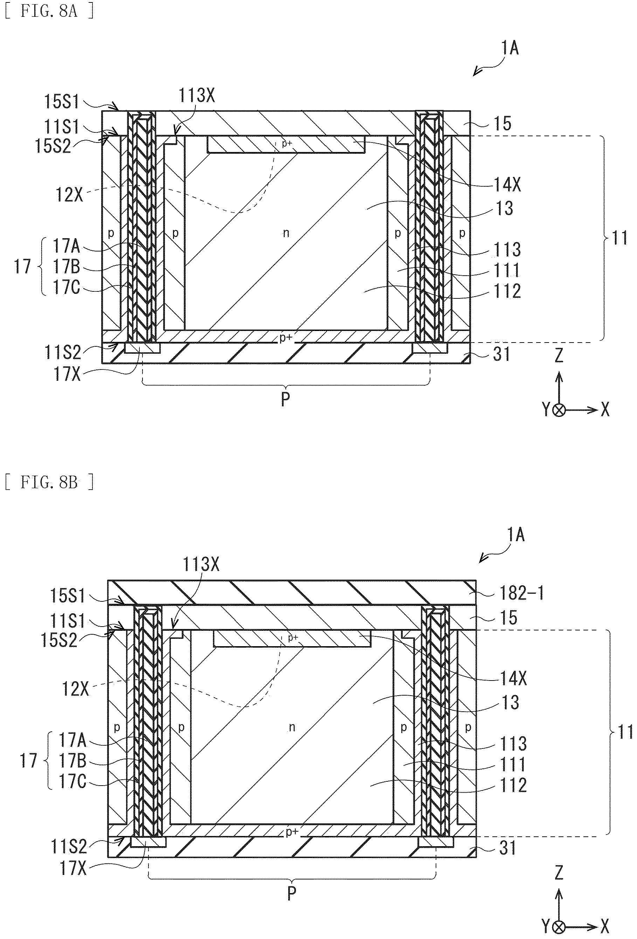

In the following, a description will be given of a method of manufacturing the photodetection devicees of the present disclosure, with reference to FIG. 8A to FIG. 8J. Here, a description will be given of the photodetection device 1A illustrated in FIG. 5, as the first modification example according to the first embodiment. FIG. 8A to FIG. 8J are schematic diagrams of a laminated cross section, each illustrating one process of the method of manufacturing the photodetection device 1A.

First, as illustrated in FIG. 8A, the semiconductor substrate 11 is prepared. Then, the p-type or n-type impurity concentration is controlled by ion implantation, and each of the p-well (p) 111, the n-type semiconductor region (n) 112, the p-type semiconductor region (p+) 113, and the p-type semiconductor region (p+) 14X is formed on the semiconductor substrate 11.

Next, the semiconductor layer 15 including, for example, silicon (Si), is formed on the first surface 1151 of the semiconductor substrate 11 by, for example, the epitaxial crystal growth method such as metal organic chemical vapor deposition method (Metal Organic Chemical Vapor Deposition: MOCVD). Then, after an oxide film such as silicon oxide (SiOx) or a nitride film such as (SiNx) is patterned as a hard mask on the first surface 15S1 of the semiconductor layer 15, for example, a through-bore penetrating, for example, the semiconductor layer 15 and the semiconductor substrate 11 is formed by etching. Subsequently, the insulating films 17B and 17C and the light shielding film 17A are formed in order inside the through-bore by, for example, a CVD (Chemical Vapor Deposition) method, a PVD (Physical Vapor Deposition) method, an ALD (Atomic Layer Deposition) method, or a vapor deposition method, or the like. This results in the pixel separator 17.

Subsequently, as illustrated in FIG. 8B, an inter-layer insulating layer 182-1 is formed on the first surface 15S1 of the semiconductor layer 15. It is to be noted that before the inter-layer insulating layer 182-1 is formed, the first surface 15S1 of the semiconductor layer 15 may be planarized by CMP (Chemical Mechanical Polishing), for example.

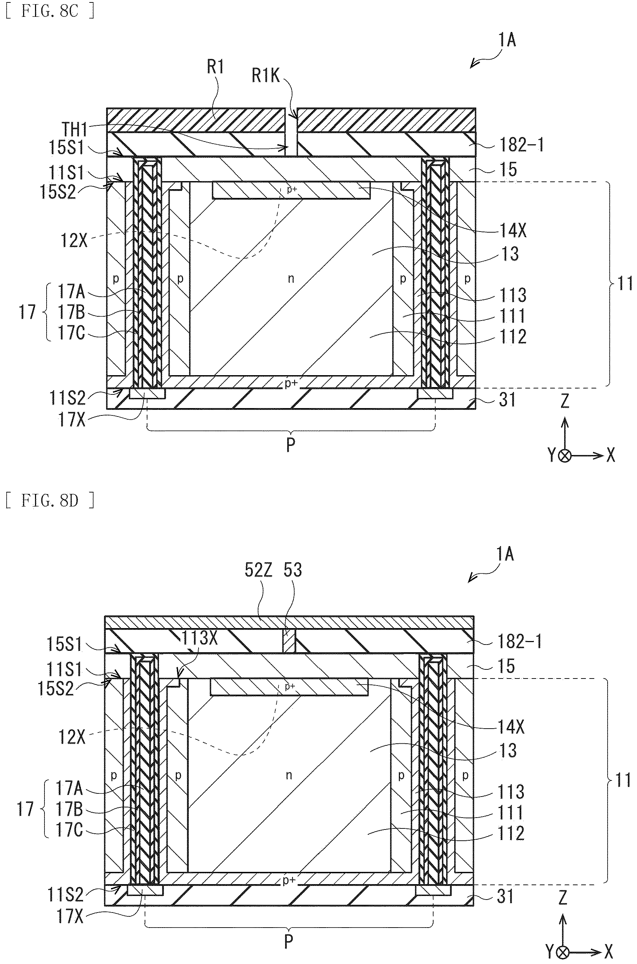

Subsequently, as illustrated I FIG. 8C, a resist mask R1 including an opening R1K is formed on the inter-layer insulating layer 182-1 using a photolithography method. Furthermore, a through-hole TH-1 is formed in the inter-layer insulating layer 182-1 by dry etching such as RIE using the resist mask R1 or wet etching. The through-hole TH1 is formed at a position that overlaps the p-type semiconductor region (p+) 14X adjacent to a middle of the light receiving section 13. After the through-hole TH1 is formed, the resist mask R1 is removed.

Subsequently, as illustrated in FIG. 8D, a polycrystalline semiconductor layer 52Z is formed so as to cover the inter-layer insulating layer 182-1, by using, for example, a polycrystalline semiconductor material such as poly-silicon to which an n-type impurity element such as P (phosphorus) or As (arsenic) is added. It is to be noted that in forming the polycrystalline semiconductor layer 52Z, for example, n-type impurities may be ion-implanted after forming a film of pure polysilicon containing no n-type impurities.

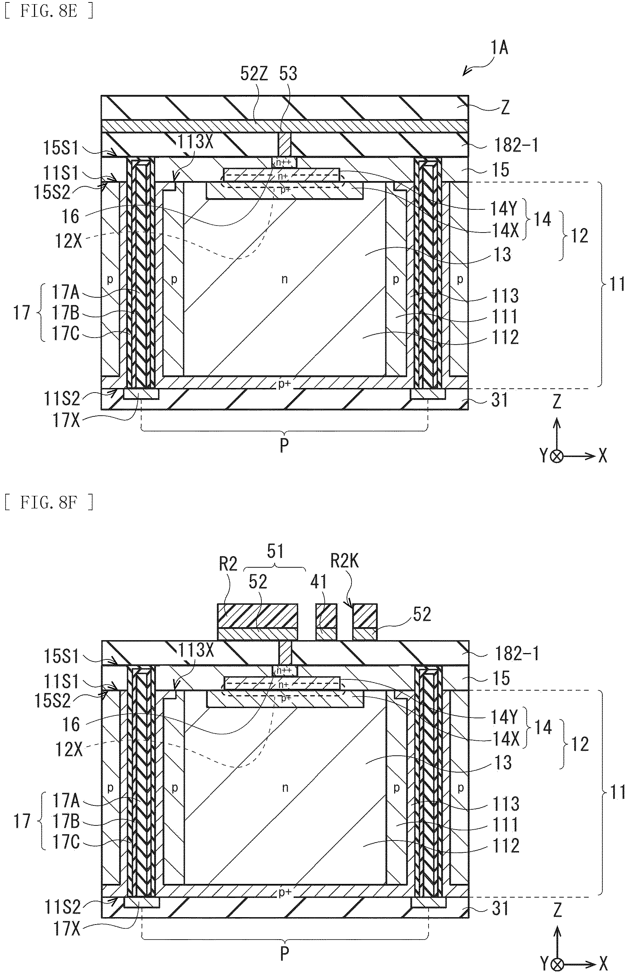

Subsequently, as illustrated in FIG. 8E, after an insulating film Z is formed on the polycrystalline semiconductor layer 52Z, the polycrystalline semiconductor layer 52Z is heated at a predetermined temperature for a predetermined period of time. Specifically, the polycrystalline semiconductor layer 52Z is heated, for example, at 900°C for 30 minutes or heated at 1050°C for 10 minutes. This diffuses, into the semiconductor layer 15, the n-type impurities contained in the polycrystalline semiconductor material that constitutes the take-out section 53. As a result, the contact layer 16 and the n-type semiconductor region (n+) 14Y are formed adjacent to the take-out section 53. In this manner, by diffusing the n-type impurities from the take-out section 53, the contact layer 16 and the n-type semiconductor region (n+) 14Y are formed in a self-aligned manner. Therefore, as compared to a case where the contact layer 16 and the n-type semiconductor region (n+) 14Y are formed by, for example, ion implantation, it is possible to form the contact layer 16 and the n-type semiconductor region (n+) 14Y in a narrower region with high precision. After the contact layer 16 and the n-type semiconductor region (n+) 14Y are formed, the insulating layer Z is removed.

Subsequently, as illustrated in FIG. 8F, after a resist mask R2 including an opening R2K is formed at a predetermined position on the polycrystalline semiconductor layer 52Z by using the photolithography method, the polycrystalline semiconductor layer 52Z is selectively removed by RIE, or the like, using the resist mask R2. As a result, the main body section 52 and the reflection layer 41 are formed at respective predetermined positions on the inter-layer insulating layer 182-1. This results in the resistor element 51 including the take-out section 53 and the main body section 52.

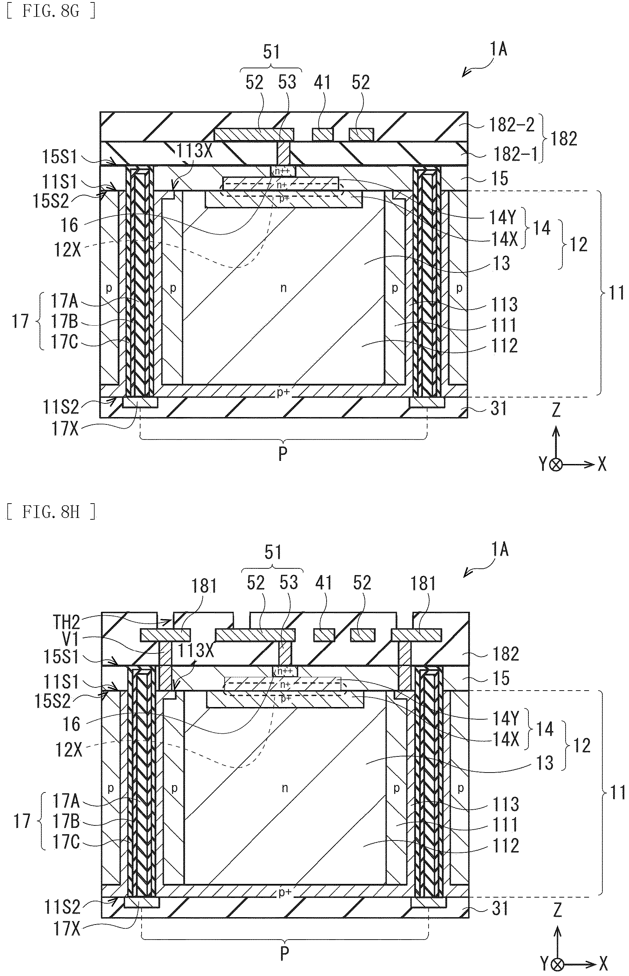

Subsequently, after the resist mask R2 is removed, as illustrated in FIG. 8G, an inter-layer insulating layer 182-2 is formed so as to cover the inter-layer insulating layer 182-1, the main body section 52, and the reflection layer 41, and an upper surface of the inter-layer insulating layer 182-2 is planarized, as necessary. This results in the inter-layer insulating layer 182 including the inter-layer insulating layer 182-1 and the inter-layer insulating layer 182-2.

Subsequently, as illustrated in FIG. 8H, a portion of the inter-layer insulating layer 182 and a portion of the semiconductor layer 15 are selectively removed by using the photolithography method, for example, to selectively form an opening at a position corresponding to the expanded portion 113X in the Z-axis direction. Then, the via V1 is formed by filling that opening with a conductive metallic material such as W (tungsten), for example. Furthermore, the inter-layer insulating layer 182 around the via V1 is selectively removed and the wiring layer 181 is formed on the via V1. Furthermore, after the entire wiring layer 181 is covered by the inter-layer insulating layer 182, a through-hole TH2 is formed on the inter-layer insulating layer 182. At this time, the through-hole TH2 is formed at a position corresponding to the wiring layer 181 and at a position corresponding to the main body section 52.

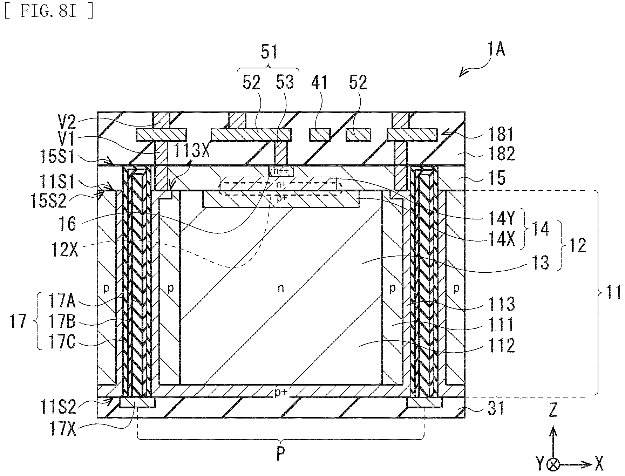

Subsequently, as illustrated n FIG. 8I, the via V2 is formed by filling the through-hole TH2 with the conductive metallic material such as W (tungsten), for example.

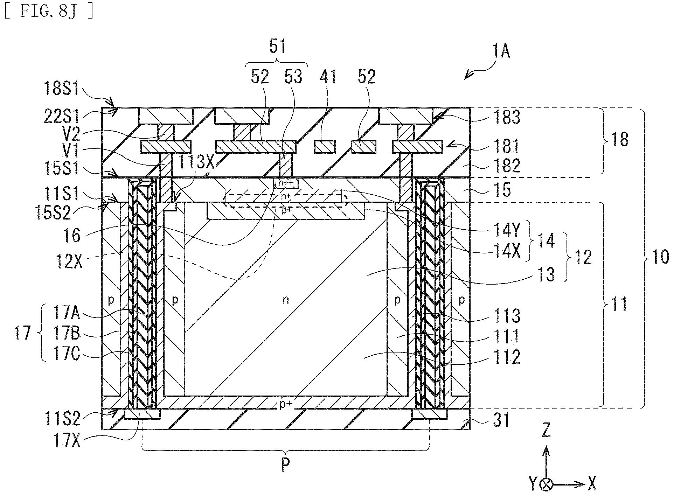

Subsequently, as illustrated in FIG. 8J, the pad electrodes 183 are each formed so as to be in contact with an upper surface of the via V2, and peripheries around the pad electrode 183 are filled with the inter-layer insulating layer 182. Furthermore, planarization of the upper surfaces of the pad electrodes 183 and the inter-layer insulating layer 182 results in the multilayer wiring layer 18 having the flat surface 18S1. This completes the sensor substrate 10.

Thereafter, the logic substrate 20 created separately is attached to the sensor substrate 10. At this time, the plurality of pad electrodes 183 and a plurality of pad portions 217 are Cu-Cu bonded, the plurality of pad electrodes 183 being exposed on the surface 18S1 of the multilayer wiring layer 18 that is the bonded surface of the sensor substrate 10, and the plurality of par portions 217 being exposed on the surface 22S of the multilayer wiring layer 22 that is the bonded surface of the logic substrate 20.

Subsequently, after the second surface 11S2 of the semiconductor substrate 11 is polished by, for example, the CMP, a light shielding portion 17X, the passivation film 31, the color filter 32, and the microlens 33 are formed in order. This completes the photodetection device 1A illustrated in FIG. 5.

### [1-4. Workings/Effects]

In this manner, according to the photodetection device 1 of the present embodiment, as well as the photodetection device 1A as the first modification example and the photodetection device 1B as the second modification example (which are hereinafter referred to as the photodetection device 1, or the like, of the present embodiment), the resistor element 51 including the polycrystalline semiconductor material is coupled to the contact layer 16 that is electrically coupled to the multiplier 14. For this reason, the structure is such that no metal comes into direct contact with the semiconductor substrate 11 such as an Si substrate, for example, no silicide reaction between Si and a metal element occurs, which makes it possible to avoid intrusion of the metal element into the semiconductor substrate 11. Therefore, structural stability of the semiconductor substrate 11 is improved, as compared to a case where the resistor element 51 includes metal. That is, because it is possible to suppress occurrence of crystal structure defects in the semiconductor substrate 11, it is possible to obtain high operation reliability of the semiconductor substrate 11 such as ensuring a sufficient dielectric strength voltage.

In addition, the resistor element 51 includes the main body section 52 extending into the XY plane and the take-out portion 53 extending in the lamination direction (Z-axis) so as to connect the contact layer 16 and the main body section 52. Therefore, it is possible to form the main body section 52 linearly and optionally set a resistance value of the resistor element 51 by adjusting a length of the path.

In addition, the resistor element 51 includes a polycrystalline semiconductor such as polysilicon, so that it is easier to achieve a higher resistance than a case where the resistor element 51 includes the metallic material, and it is also possible to reduce unintended parasitic capacitance. This further makes it possible to reduce necessary consumed power during operation, and is advantageous for speed-up.

Furthermore, according to the photodetection device 1, or the like, of the present embodiment, it is possible to produce a diffusion layer such as the contact layer 16 in a self-aligned manner, by diffusing the n-type impurities contained in the take-out section 53 of the resistor element 51. For this reason, ion implantation into the semiconductor substrate 11 is not necessary to form the diffusion layer, thereby making it possible to maintain the crystal structure of the semiconductor substrate 11 stably.

In addition, the resistor element 51 constitutes the clamping circuit 50 as a protection circuit. Therefore, it is possible to avoid damaging the readout circuit 75, or the like, due to overvoltage to be generated when the light receiving element 12 is irradiated with laser beams with large light quantities.

In addition, the plurality of reflection layers 41 is provided in the photodetection devicees 1A and 1B, so that it is possible to reflect light that passes through the light receiving section 13 after entering the second surface 11S2 and to cause the light to enter the light receiving section 13 again. Therefore, it is possible to achieve higher light detection sensitivity.

As described above, according to the photodetection device, or the like, of the present embodiment, it is possible to ensure the high reliability while coping with downsizing.

### <2. Second Embodiment>

### [2-0. History]

As a light receiving element that generates a signal in response of reception of a photon, for example, the SPAD (Single Photon Avalanche Diode: single photon avalanche diode) element has been known. A light receiving apparatus that uses the SPAD element as the light receiving element adopts a configuration in which a voltage equal to or larger than a breakdown voltage is applied to an anode electrode (or a cathode electrode) of the SPAD element to use the SPAD element, due to the configuration of the light receiving apparatus (see Japanese Unexamined Patent Application Publication No. 2019-125717, for example). In the meantime, in a case where the SPAD element is irradiated with laser beams with light quantities equal to or larger than expected (equal to or larger than predetermined light quantities) such as a case where the SPAD element is directly irradiated with laser beams, internal impedance of the SPAD element is significantly reduced due to a stronger influence of the large light quantities on photoelectric conversion. As a result, an excessive voltage is applied to a readout circuit which reads out a signal generated by the SPAD element, and thus, there is a possibility that circuit elements constituting the readout circuit may be damaged. Hence, in order to protect the readout circuit, a configuration is proposed in which a resistor element including metal is directly coupled to the SPAD element (Japanese Unexamined Patent Application Publication No. 2020-153929, for example). In recent days, however, there has been an increasing demand for further downsizing of such light receiving elements and photodetection devicees provided with the light receiving elements. Under these circumstances, the present applicant has come to provide the photodetection device with the high reliability while coping with downsizing.

### [2-1.] Configuration of Photodetection device

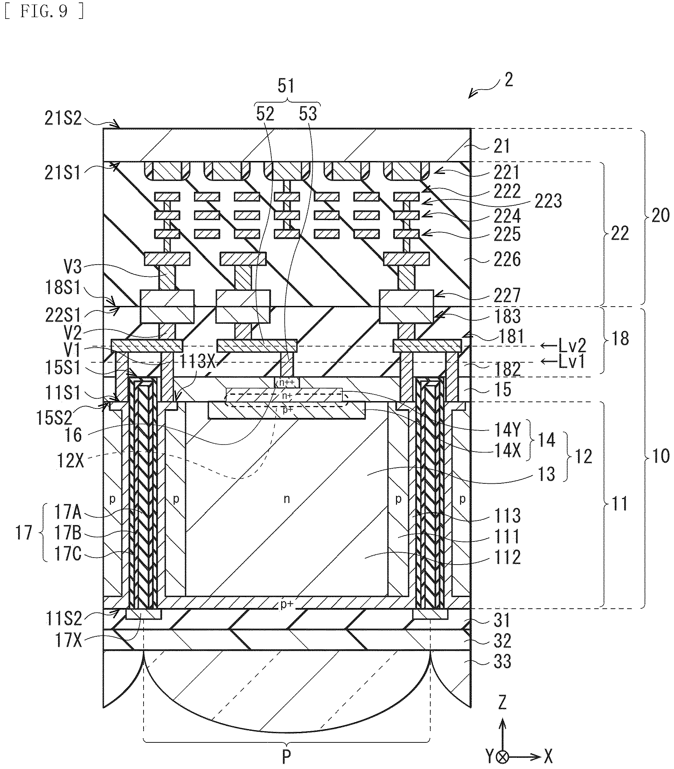

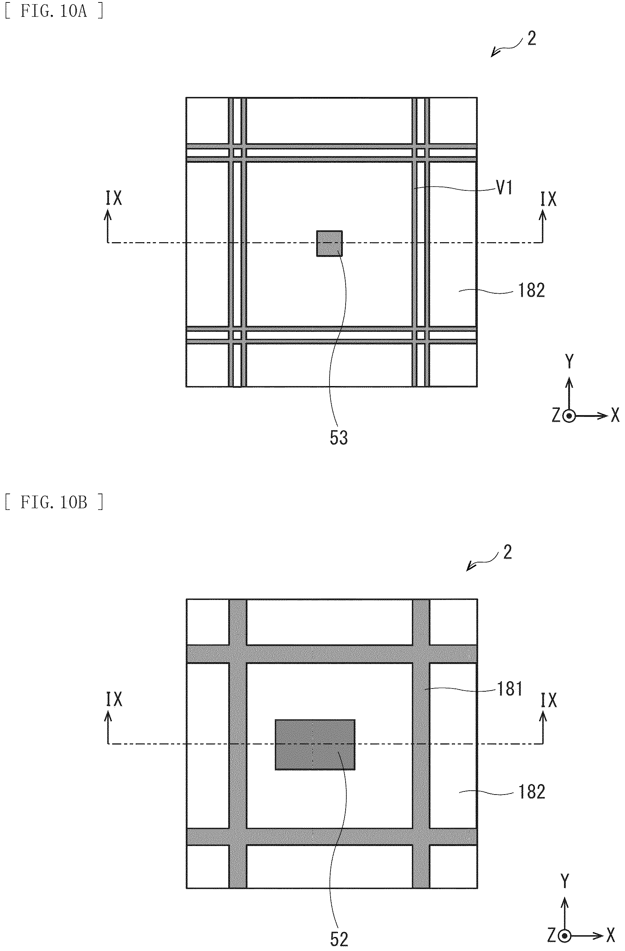

FIG. 9 schematically illustrates an example of a cross-sectional configuration of a photodetection device 2 according to a second embodiment of the present disclosure. FIGs. 10A and 10B are schematic cross-sectional diagrams, each illustrating a configuration example of a horizontal cross section of the photodetection device 2 illustrated in FIG. 9. However, FIG. 10A illustrates a horizontal cross section at a height position Lv1 illustrated in FIG. 9, and FIG. 10B illustrates a horizontal cross section at a height position Lv2 illustrated in FIG. 9. In addition, FIG. 9 illustrates a cross section in an arrow direction along a cutting-plane line IX-IX illustrated in FIGs. 10A and 10B, respectively.

It is to be noted that in the photodetection device 2 of the present embodiment, components common to the components of the photodetection device 1 of the first embodiment described above are denoted with same reference numerals, and that a description of the photodetection device 2 is omitted appropriately.

As illustrated in FIG. 9 and FIG. 10A, the vias V1 electrically coupled to the p-type semiconductor region (p+) 113 as an anode are provided to surround a region of each pixel P corresponding to the light receiving section 13 in a cross section parallel to the XY plane. In addition, the vias V1 surrounding the light receiving sections 13 of the adjacent pixels P are provided to be mutually connected. This makes it possible to reduce contact resistance on anode side.

In addition, the pixel separator 17 is provided inside the semiconductor substrate 11 so as to surround the light receiving section 13 in the cross section parallel to the XY plane, and separates the plurality of pixels P from each other. Furthermore, the wiring layer 181 is provided to overlap the pixel separator 17 in the thickness direction (Z-axis direction) and to form a grid shape in the cross section parallel to the XY plane, so that the wiring layer 181 is electrically coupled to the vias V1.

In the photodetection device 2, the vias V1 and the take-out section 53 include the polycrystalline semiconductor material such as polysilicon. In the photodetection device 2, the wiring layer 181 and the main body section 52 include, for example, a single-layer film including the metallic material such as tungsten. In the photodetection device 2, the via V2 may include Cu (copper).

In the photodetection device 2, it is desirable that the resistor element 51 have, for example, a resistance value of SkS2 or higher. In addition, polysilicon that constitutes the take-out section 53 of the resistor element 51 and the vias V1 has the impurity concentration of, for example, 1019 atoms/cm3 or higher and less than 1021 atoms/cm3.

### [2-2. Workings/Effects]

In this manner, in the photodetection device 2 of the present embodiment, the resistor element 51 including the take-out section 53 including the polycrystalline semiconductor material is coupled to the contact layer 16 that is electrically coupled to the multiplier 14. As a result, the structure in which metal is not in direct contact with the semiconductor substrate 11 such as an Si substrate, for example, does not cause the silicide reaction between Si and the metal element and makes it possible to avoid intrusion of the metal element into the semiconductor substrate 11. Therefore, the structural stability of the semiconductor substrate 11 is improved as compared to the case in which the resistor element 51 includes metal. That is, because it is possible to suppress occurrence of crystal structure defects in the semiconductor substrate 11, it is possible to obtain the high reliability of the semiconductor substrate 11 such as ensuring the sufficient dielectric strength voltage. Moreover, because the resistor element 51 is embedded in the multilayer wiring layer 18, it is possible to cope with further downsizing and thickness reduction.

In addition, in the photodetection device 2, the resistor element 51 constitutes the clamping circuit 50 as a protection circuit. Therefore, it is possible to avoid damaging the readout circuit 75, or the like, due to overvoltage to be generated when the light receiving element 12 is irradiated with laser beams with large light quantities.

In addition, in the photodetection device 2, the vias V1 are provided to surround the region of each pixel P corresponding to the light receiving section 13 in the cross section parallel to the XY plane and the vias V1 surrounding the light receiving sections 13 of the adjacent pixels P are connected to each other. This makes it possible to reduce the contact resistance on the anode side. It is to be noted that in order to further reduce the contact resistance on the anode side, the vias V1 may include a metallic material, such as W (tungsten), having lower resistance than the polycrystalline semiconductor material, rather than including the polycrystalline semiconductor material such as polysilicon.

As described above, according to the photodetection device, or the like, of the present embodiment, it is possible to ensure the high operation reliability while coping with downsizing.

### [2-3. Modification Example of Photodetection device]

### (First Modification Example)

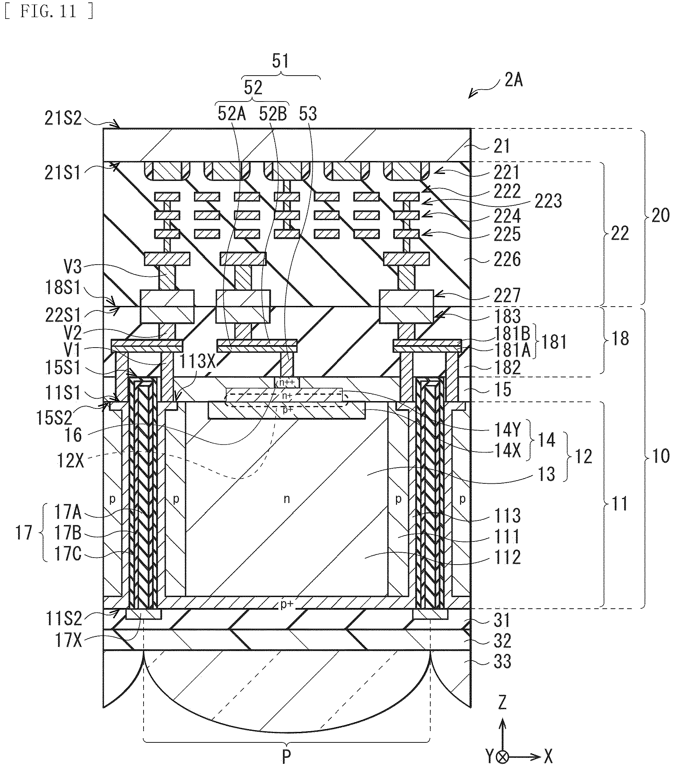

FIG 11 schematically illustrates an example of a laminated cross-sectional configuration of a photodetection device 2A as a first modification example according to the second embodiment of the present disclosure.

As illustrated in FIG. 11, in the photodetection device 2A, the wiring layer 181 and the main body section 52 each have a two-layer structure. A configuration of the photodetection device 2Ais substantially same as the configuration of the photodetection device 2 except for that point.

In the photodetection device 2A, the main body section 52 extending parallel to the XY plane has the two-layer structure including a first layer 52Athat is in contact with an upper end of the take-out section 53 and a second layer 52B that covers the first layer 52A and is in contact with the via V2. In addition, the wiring layer 181 has a two-layer structure including a first layer 181A that is in contact with an upper end of the via V1 and a second layer 181B that covers the first layer 181A and is in contact with the via V2. Here, the first layer 52A and the first layer 181A may mutually include a same material, mutually have a same thickness, and be mutually located at a substantially same level. The first layer 52A and the first layer 181A are, for example, WSi (tungsten silicon) layers. In addition, the second 52B layer and the second layer 181B may mutually include the same material, mutually have the same thickness, and be mutually located at substantially the same level. The second layer 52B and the second layer 181B are, for example, the W (tungsten) layers.

In this manner, in the photodetection device 2A of the present embodiment, the take-out section 53 and the vias V1 including polysilicon are in contact with the first layer 52A and the first layer 181A that are WSi (tungsten silicon) layers. In contrast, in the photodetection device 2 of the second embodiment described above, the take-out section 53 and the vias V1 including polysilicon are in contact with the main body section 52 and the first layer 181, respectively, that include W(tungsten). As a result, it is possible to stabilize the contact resistance between the take-out section 53 and the main body section 52 and the contact resistance between the vias V1 and the wiring layer 181 lower than the photodetection device 2 of the second embodiment described above.

### (Second Modification Example)

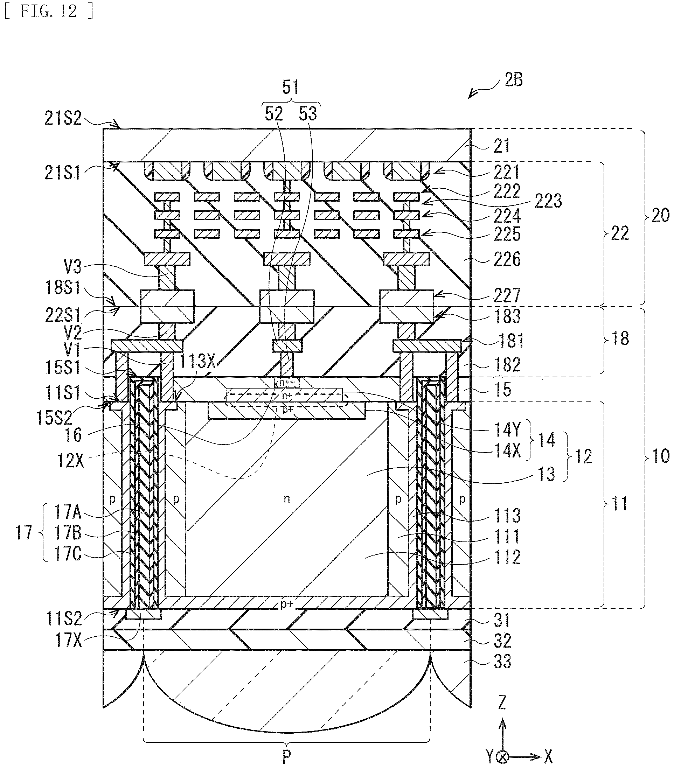

FIG. 12 schematically illustrates an example of a laminated cross-sectional configuration of a photodetection device 2B as a second modification example according to the second embodiment of the present disclosure.

As illustrated I FIG. 12, in the photodetection device 2B, the via V2 is disposed directly on the take-out section 53 of the resistor element 51. That is, the take-out section 53 and the via V2 provided on the main body section 52 are provided at a position where the via V2, the take-out section 53, and the main body section 52 overlap each other in the Z-axis direction. A configuration of the photodetection device 2B is substantially same as the configuration of the photodetection device 2 except for that point.

In this manner, the via V2 is provided directly on the take-out section 53 in the photodetection device 2B of this modification example, so that it is possible to make dimensions of the main body section 52 in the XY plan direction smaller.

### (Third Modification Example)

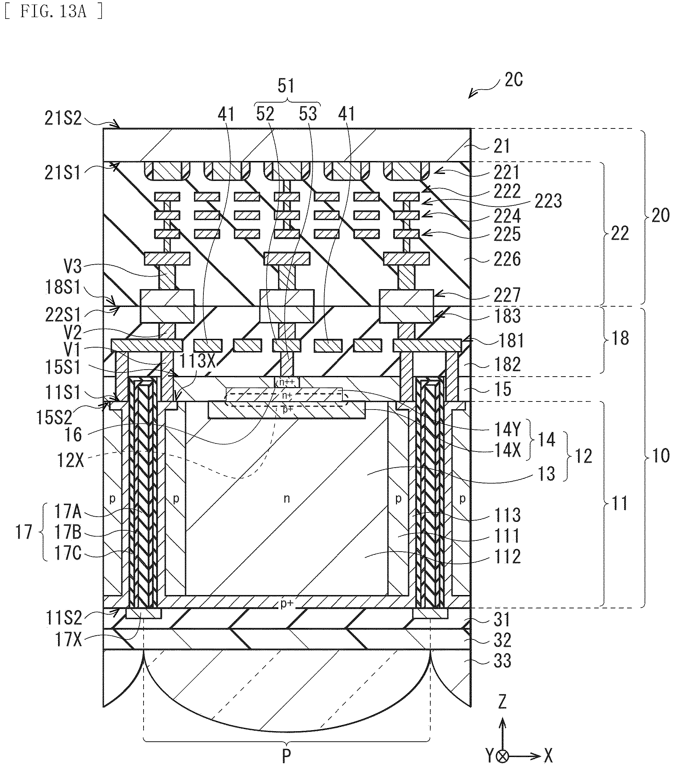

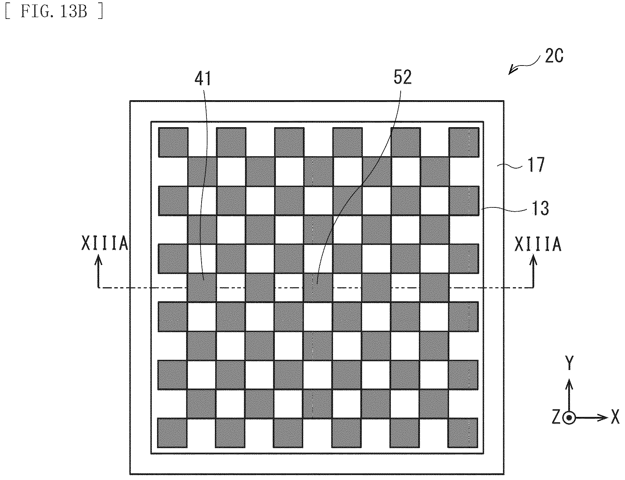

FIG. 13A schematically illustrates an example of a laminated cross-sectional configuration of a photodetection device 2C as a third modification example according to the second embodiment of the present disclosure. FIG. 13B is a schematic diagram illustrating a planar configuration example (planar layout) of the photodetection device 2C illustrated in FIG. 13A. It is to be noted that FIG. 13A illustrates a cross section in an arrow view direction along a cutting-plane line XIIIA-XIIIA illustrated in FIG. 13B. In addition, FIG. 13B illustrates an XY cross section of a level including the reflection layers 41, or the like.

As illustrated in FIGs. 13A and 13B, the photodetection device 2C further includes the plurality of reflection layers 41. A configuration of the photodetection device 2C is same as the configuration of the photodetection device 2B except for that point. The plurality of reflection layers 41 is disposed discretely along the XY plane. Specifically, the plurality of reflection layers 41 is arrayed two-dimensionally and periodically so as to form a check pattern along the XY plane. That is, gaps are provided between the reflective layers 41 that are next to each other in an X-axis direction and a Y-axis direction. In the photodetection device 2C, the plurality of reflection layers 41 is provided at the same level as, for example, the main body section 52 and the wiring layer 181. The plurality of reflection layers 41 includes, for example, a polycrystalline semiconductor such as polysilicon. In that case, the main body section 52 and the wiring layer 181 may also include a same kind of constituent material (same kind of polycrystalline semiconductor such as polysilicon) as the constituent material of the reflection layer 41. This is because it is possible to form the reflection layers 41, the main body section 52, and the wiring layer 181 collectively.

In this manner, in the photodetection device 2C of this modification example, the plurality of reflection layers 41 is provided, so that it is possible to reflect the light that passes through the light receiving section 13 after entering the second surface 11S2 and to cause the light to enter the light receiving section 13 again. Therefore, it is possible to obtain the higher light detection sensitivity.

### (Fourth Modification Example)

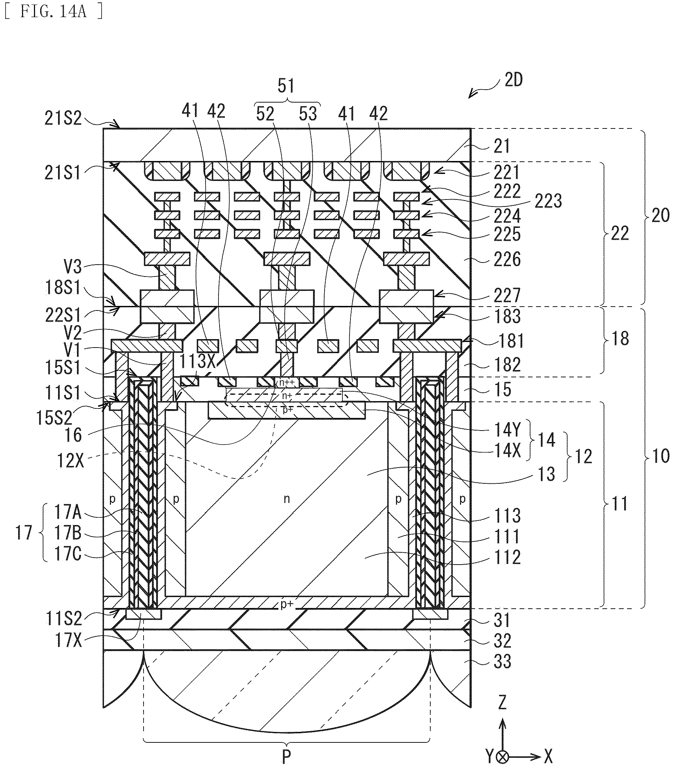

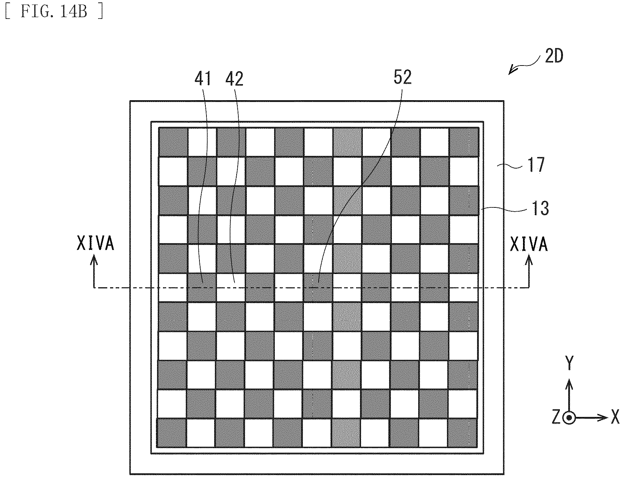

FIG. 14A schematically illustrates an example of a laminated cross-sectional configuration of a photodetection device 2D as a fourth modification example according to the second embodiment of the present disclosure. FIG. 14B is a schematic diagram illustrating a planar configuration example (planar layout) of the photodetection device 2D illustrated in FIG. 14A. It is to be noted that FIG. 14A illustrates a cross section in an arrow direction along a cutting-plane line XIVA-XIVA illustrated in FIG. 14B.

As illustrated in FIG. 14A and FIG. 14B, the photodetection device 2C further includes the plurality of reflection layers 41 and a plurality of reflection layers 42. A configuration of the photodetection device 2D is same as the configuration of the photodetection device 2B except for that point.

The plurality of reflection layers 41 is disposed discretely along the XY plane. Specifically, the plurality of reflection layers 41 is arrayed two-dimensionally and periodically so as to form a check pattern along the XY plane. That is, the gaps are provided between the reflective layers 41 that are next to each other in the X-axis direction and the Y-axis direction. In the photodetection device 2D, the plurality of reflection layers 41 is provided at the same level as, for example, the main body section 52 and the wiring layer 181. The plurality of reflection layers 41 includes, for example, a polycrystalline semiconductor such as polysilicon. In that case, the main body section 52 and the wiring layer 181 may also include the same kind of constituent material (same kind of polycrystalline semiconductor such as polysilicon) as the constituent material of the reflection layer 41. This is because it is possible to form the reflection layers 41, the main body section 52, and the wiring layer 181 collectively.

The plurality of reflection layers 42 is also disposed discretely along the XY plane. Specifically, the plurality of reflection layers 42 is arrayed two-dimensionally and periodically so as to form a check pattern along the XY plane. However, the plurality of reflection layers 42 is provided at a level different from the level where the plurality of reflection layers 41 is provided, and is provided at positions in the XY plane that fill gap regions between the plurality of reflection layers 41. That is, the plurality of reflection layer 42 is provided at positions corresponding to the gaps between the plurality of reflection layers 41 in the thickness direction (Z-axis direction). The plurality of reflection layers 42 is embedded in, for example, the semiconductor layer 15. The plurality of reflection layers 42 may include, for example, SiO2.

In this manner, in the photodetection device 2D of this modification example, the plurality of reflection layers 41 and the plurality of reflection layer 42 are provided, so that it is possible to more efficiently reflect the light that passes through the light receiving section 13 after entering the second surface 11S2 and to cause the light to enter the light receiving section 13 again. Therefore, it is possible to achieve the even higher light detection sensitivity.

### (Fifth Modification Example)

In the photodetection device 2 of the second embodiment described above, while the via V1 and the take-out section 53 include a polycrystalline semiconductor material such as polysilicon, the wiring layer 181 and the main body section 52 include a metallic material such as tungsten, or the like. However, the present disclosure is not limited to this. For example, in addition to the via V1 and the take-out section 53, the wiring layer 181 and the main body section 52 may also include a polycrystalline semiconductor such as polysilicon. This is because it is possible to form the via V1, the take-out section 53, the wiring layer 181, and the main body section 52 collectively. In that case, it is desirable that the via V2 include W (tungsten) instead of Cu (copper). This is because mutual diffusion is likely to occur in a case where polysilicon comes in direct contact with Cu. It is possible to avoid such mutual diffusion at a contact interface between polysilicon and W (tungsten).

### <3. Third Embodiment>

### [3-1. Configuration]

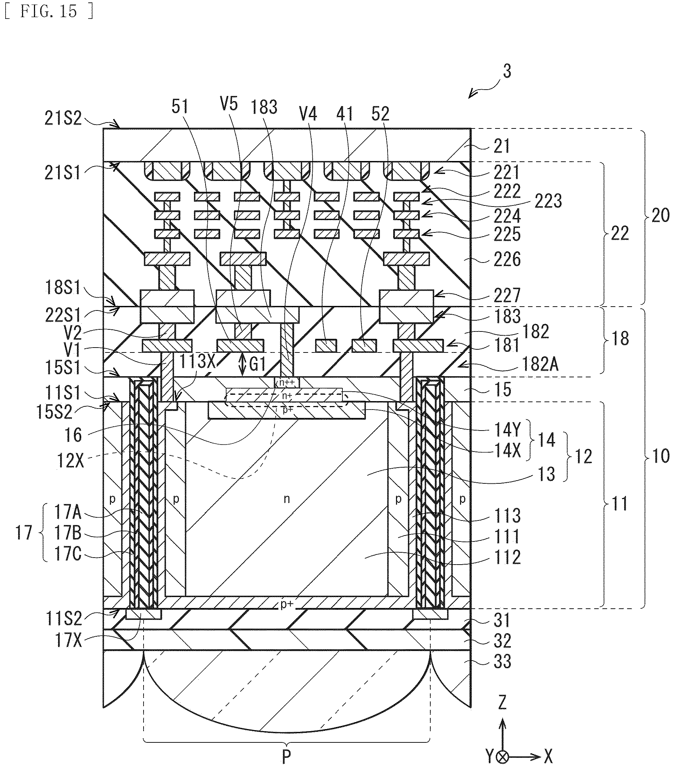

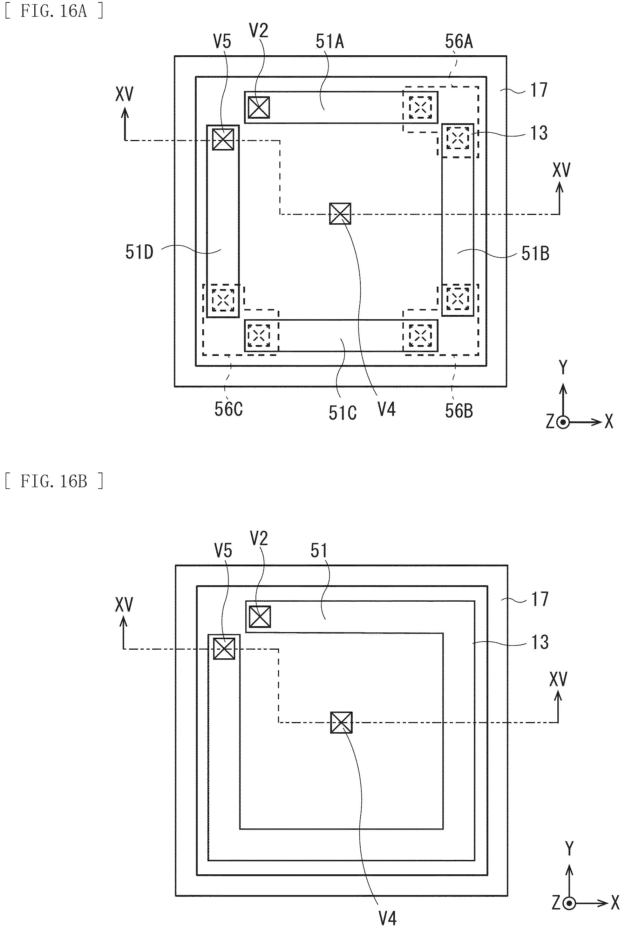

FIG. 15 schematically illustrates an example of a laminated cross-sectional configuration of a photodetection device 3 according to a third embodiment of the present disclosure. FIGs. 16A and 16B are schematic cross-sectional diagrams, each illustrating a first configuration example and a second configuration example of a horizontal cross section of the photodetection device 3 illustrated in FIG. 15. However, FIGs. 16A and 16B illustrate the horizontal cross section at a position including the resistor element 51 illustrated in FIG. 15. In addition, Fig. 15 illustrates a cross section in an arrow direction along a cutting-plane line XV-XV illustrated in FIGs. 16A and 16B, respectively.

In the photodetection device 3, the resistor element 51 and the contact layer 16 are electrically coupled via a wiring layer 183 as a fourth wiring line. The wiring layer 183 is provided on opposite side to the semiconductor substrate 11 when viewed from the resistor element 51. More specifically, the resistor element 51 is coupled to the contact layer 16 through a via V4 coupled to an upper end of the contact layer 16, the wiring layer 183, and a via V5 sandwiched between the wiring layer 183 and the resist element 51. The via V4 extends inside of the inter-layer insulating layer 182 in the Z-axis direction so as to connect the contact layer 16 and the wiring layer 183. The via V5 is provided at a same level as the via V2.

Here, it is desirable that a gap G1 between a lower surface of the resistor element 51 and the upper surface of the contact layer 16 (see FIG. 15), that is, a thickness of a portion 182A of the inter-layer insulating layer 182, sandwiched between the resistor element 51 and the contact layer 16, be 150nm or larger when the relative permittivity ε of a material constituting the inter-layer insulating layer 182 is 4.2. This is because in a case where the thickness G1 is smaller than this, there is a possibility that the strong electric field may be generated in the unintended location between the main body section 52 and the multiplier 14, that is, the location other than the first coupling section C1, resulting in unintended avalanche multiplication of electrons.

As illustrated in FIG. 16A, for example, the resistor element 51 is such that resistance portions 51Ato 51D, each extending approximately linearly along the XY plane, are connected to each other by coupling portions 56A to 56C including copper, or the like. The resistance portions 51A to 51D include, for example, a polycrystalline semiconductor such as polysilicon. In a configuration example of the resistor element 51 illustrated in FIG. 16A, the resistor element 51 has only the resistance portions 51A to 51D that extend approximately linearly, so that it is easier for the resistor element 51 to control own resistance value than a form including a curved portion.

As illustrated in FIG. 16B, for example, the resistor element 51 may have a shape that goes around along an inner edge of the pixel separator 17 that partitions the pixels P, in the XY plane. As compared to FIG. 16A, it is possible to make the path length of the resistor element 51 longer and to obtain a larger resistance value in a limited region. As compared to FIG. 16B, however, because the resistor element includes a bent portion, it is somewhat difficult to obtain a desired resistance value.

### [3-2. Workings/Effects]

In this manner, the resistor element 51 is also provided in the photodetection device 3, so that it is possible to avoid the damage to the readout circuit 75, or the like, from the overvoltage to be generated, for example, when the light receiving element 12 is irradiated with laser beams with large light quantities.

### [3-3. Modification Examples]

### (First Modification Example)

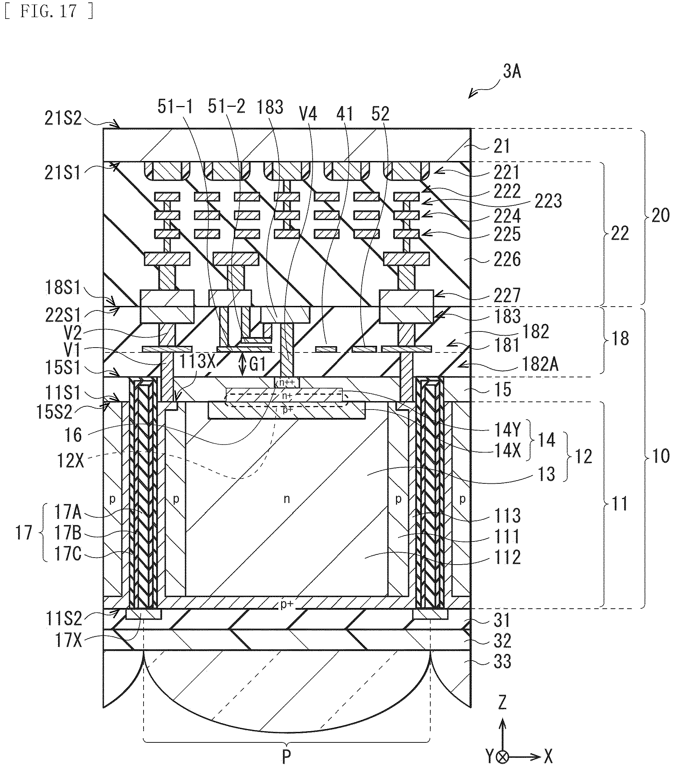

FIG. 17 schematically illustrates an example of a laminated cross-sectional configuration of a photodetection device 3A as a first modification example according to a third embodiment.

As illustrated in FIG. 17, in the photodetection device 3A, the resistor element 51 includes two or more resistor layers 51-1 and 51-2 provided at mutually different levels. A configuration of the photodetection device 3A is substantially same as the configuration of the photodetection device 3 except for that point.

In the photodetection device 3A, the resistor element 51 includes the resistor layer 51-1 and the resistor layer 51-2 laminated as an upper layer of the resistor layer 51-1. As a result, it is possible to obtain a larger resistance value than the photodetection device 3, or the like, without expanding an occupied area in the XY plane.

### <4. Fourth Embodiment>

### [4-0. History]

As already described, in a case where the SPAD element is irradiated with laser beams with light quantities equal to or larger than expected (equal to or larger than predetermined light quantities), an excessive voltage is applied to a readout circuit which reads out a signal generated by the SPAD element, and thus, there is a possibility that circuit elements constituting the readout circuit may be damaged. Also as described above, it is effective, as a countermeasure against this, to insert a resistor element between the SPAD element and the readout circuit to prevent inflow of the overcurrent into the readout circuit. Furthermore, as described above, a polycrystalline semiconductor such as polysilicon may be used as the resistor element, instead of a metallic material.

However, in a case where a polycrystalline semiconductor such as polysilicon is coupled to a cathode as a resistor element, a potential will be same as the cathode (+3V, for example), and the potential inside the semiconductor substrate may be modulated. In that case, the dielectric strength voltage of an insulating film between polysilicon as the resistor element and the semiconductor substrate will decrease. In addition, dark currents may increase.

As means to avoid such modulation of the potential inside the semiconductor substrate, it is effective to increase a thickness of the insulating film between the resistor element including polysilicon and the semiconductor substrate. It is to be noted that it is also possible to avoid the modulation of the potential (potential distribution) inside the semiconductor substrate by disposing the resistor element including polysilicon directly on an element separation region, and not directly on a pixel (light receiving region). In this case, however, making the resistor element larger to obtain a sufficient resistant value expands the element separation region accordingly, thus relatively narrowing the light receiving region.

Hence, the present applicant has come to provide the photodetection device with the high reliability while coping with downsizing.

### [4-1. Configuration]

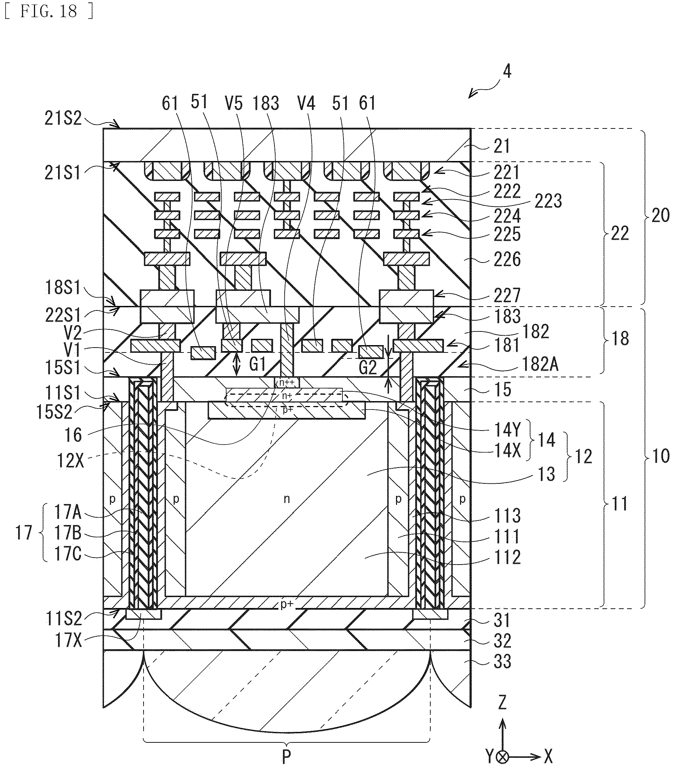

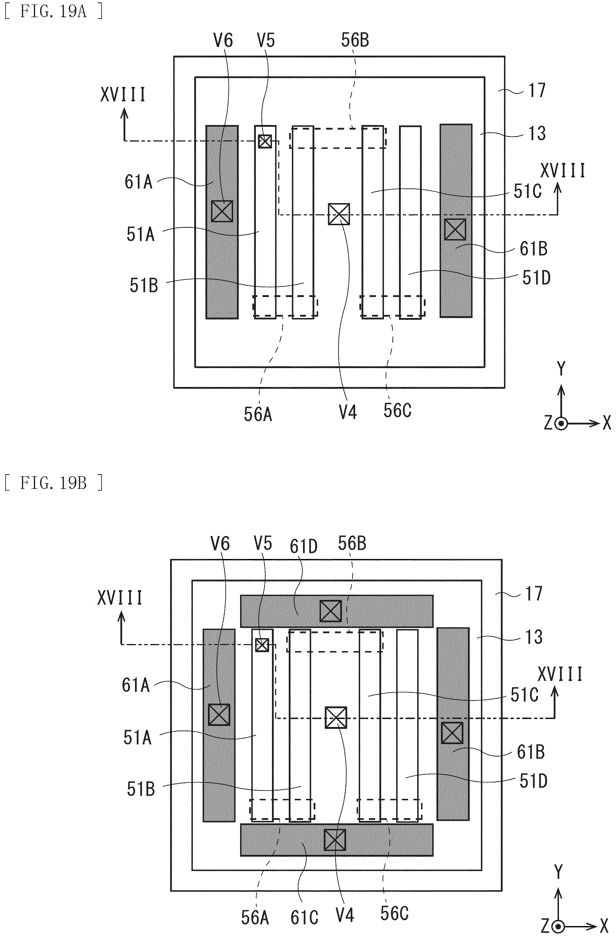

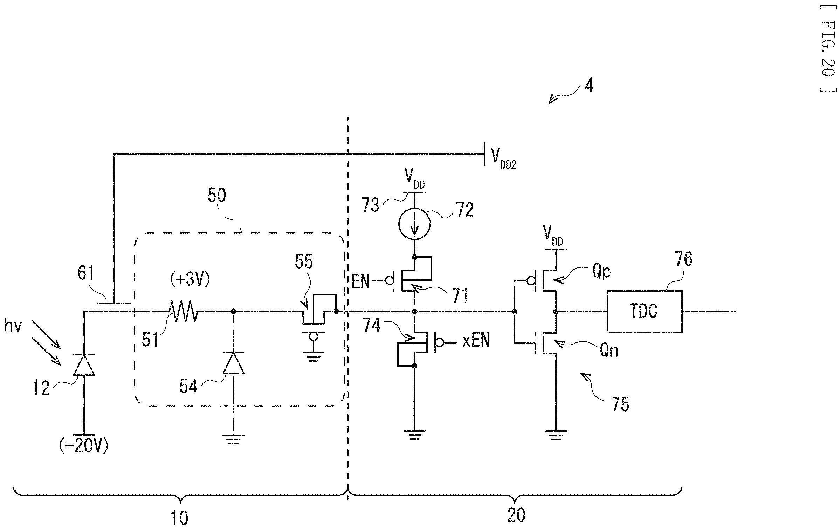

FIG. 18 schematically illustrates an example of a cross-sectional configuration of a photodetection device 4 according to a fourth embodiment of the present disclosure. FIGs. 19A and 19B are schematic diagrams illustrating a first configuration example and a second configuration example of a planar layout of the photodetection device 4 illustrated in FIG. 18. In FIGs. 19A and 19B, however, a description is mainly given of shapes, sizes, and layout positions of an electrode body (to be described below) and the resistor element 51, and a description of some of other components is omitted. In addition, FIG. 18 illustrates a cross section in an arrow direction along a cutting-plane line XVIII-XVIII illustrated in FIGs. 19A and 19B, respectively. Furthermore, FIG. 20 is a circuit diagram illustrating an example of an equivalent circuit of the unit pixel P of the photodetection device 4 illustrated in FIG. 18.

As illustrated in FIG. 18, or the like, the photodetection device 4 further includes the electrode body 61. As illustrated in FIG. 20, a voltage different from a voltage given to the resistor element 51 is applied to the electrode body 61. A polarity of the voltage to be applied to the electrode body 61 may be a reverse polarity to a polarity of the voltage applied to the resistor element 51. That is, for example, in a case where a voltage of +3V is applied to the resistor element 51, a voltage of -3V, for example, may be applied to the electrode body 61 from a power supply voltage VDD2 (see FIG. 20) via a via V6 (see FIGs. 19A and 19B). It is to be noted that a constituent material of the electrode body 61 may be same as a constituent material of the resistor element 51, for example. Specifically, it is possible that the electrode body 61 include a polycrystalline semiconductor such as polysilicon. However, the electrode body 61 may include a metallic material such as W (tungsten) or Cu (copper).

As illustrated in FIG. 18, in the photodetection device 4, a gap between the electrode body 61 and the first surface 15S1 may be narrower than the gap G1 between the resistor element 51 and the first surface 15S1.

In the first configuration example illustrated in FIG. 19A, the resistor element 51 has, for example, four resistance portions 51A to 51D, each forming a rectangular planar shape that extends in the Y-axis direction. The four resistance portions 51A to 51D are coupled in series to each other via the coupling portions 56A to 56C that include copper, or the like. In addition, in the first configuration example illustrated in FIG. 19A, two electrode bodies 61A and 61B are provided as the electrode body 61. Similarly to the resistance portions 51A to 51D, the electrode bodies 61A and 61B each have, for example, a rectangular planar shape, each extending in the Y-axis direction. The electrode body 61A is provided, for example, between the resistance portion 51A and the pixel separator 17 in the light receiving region where the light receiving section 13 is provided. In addition, the electrode body 61B is provided, for example, between the resistance portion 51D and the pixel separator 17 in the light receiving region where the light receiving section 13 is provided.

In the second configuration example illustrated in FIG. 19B, two electrode bodies 61C and 61D are further provided as the electrode body 61, in addition to the first configuration example illustrated in FIG. 19A. The electrode bodies 61C and 61D each have a rectangular planar shape extending in the X-axis direction. The electrode bodies 61C and 61D are provided in gaps between the four resistance portions 51A to 51D and the pixel separator 17.

### [4-2. Workings/Effects]

In this manner, the photodetection device 4 of the present embodiment further includes an electrode body that is provided at a position facing the first surface 11S1 and to which a voltage different from the voltage given to the resistor element 51 is given. Therefore, as compared to the configuration in which no electrode body is provided, such as the photodetection device 3 of the third embodiment described above, it is possible to suppress the modulation of the potential inside the semiconductor substrate 11 in the direction along the first surface 11S1. As a result, the sufficient dielectric strength voltage is ensured without increasing a thickness of an insulating layer 182A provided between the resistor element 51 and the contact layer 16. Moreover, it is possible to suppress generation of dark currents along the first surface 11S1 of the semiconductor substrate 11 without increasing the thickness of the insulating layer 182A. Consequently, it is possible to avoid malfunctioning of the light receiving element 12. In addition, provision of the electrode body 61 to which the voltage different from the voltage of the cathode (voltage of the resistor element 51) is applied makes it possible to provide the resistor element 51 in a region of the light receiving section 13, rather than in a region of the pixel separator 17. Therefore, in the photodetection device 4, it is possible to ensure a sufficiently large region of the light receiving section 13 and obtain sufficient light receiving sensitivity.

Furthermore, provision of the electrode body 61 at a position facing the first surface 11S1 on side opposite to the light entering surface of the semiconductor substrate 11 makes it possible to diffuse, while reflecting, photons that pass through the semiconductor substrate 11, and to cause the photons to enter the light receiving section 13 of the semiconductor substrate 11 again. That is, as compared to a case where no electrode body 61 is provided, a length of a path through which the photons that re-entered the light receiving section 13 of the semiconductor substrate 11 travel, that is, an actual optical path length inside the light receiving section 13, becomes longer. Therefore, in the photodetection device 4, quantum efficiency is improved and the light receiving sensitivity is increased.

Furthermore, by making the gap G2 between the electrode body 61 and the first surface 15S1 narrower than the gap G1 between the resistor element 51 and the first surface 15S1, it is possible to suppress the modulation of the potential inside the semiconductor substrate 11 more effectively, while ensuring the dielectric strength voltage of the portion 182A of the inter-layer insulating layer 182 between the resistor element 51 and the first surface 15S1 more sufficiently.

### [4-3. Modification Examples]

The present embodiment may include, for example, various kinds of modification examples to be described below. It is possible to expect that the following first to third modification examples also have similar effects to the photodetection device 4 of the above-described embodiment.

### (First Modification Example)

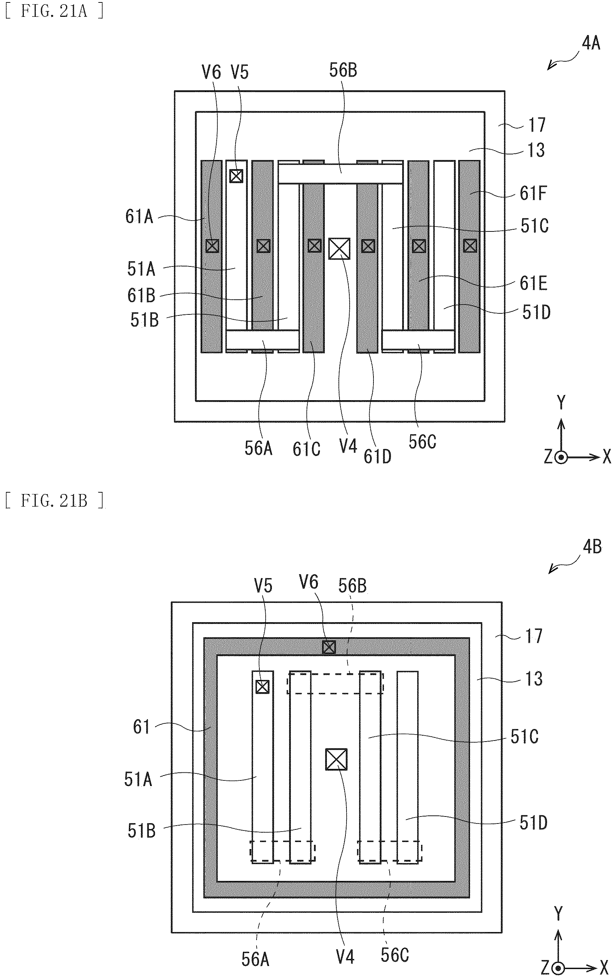

FIG. 21A schematically illustrates an example of a planar layout of a photodetection device 4A as a first modification example according to the fourth embodiment of the present disclosure. In the photodetection device 4A, the six electrode bodies 61A to 61F each extending in the Y-axis direction are arranged in the X-axis direction. In addition, the resistance potions 51A to 51D that each extend in the Y-axis direction and constitute the resistor element 51 are provided. The resistance portion 51A is disposed between the electrode body 61A and an all-pole body 61B. The resistance portion 51B is disposed between the electrode body 61B and an all-pole body 61C. The resistance portion 51C is disposed between the electrode body 61D and an all-pole body 61E. The resistance portion 51D is disposed between the electrode body 61E and an all-pole body 61F.

### (Second Modification Example)

FIG. 21B schematically illustrates an example of a planar layout of a photodetection device 4B as a second modification example according to the fourth embodiment of the present disclosure. In the photodetection device 4B, the one electrode body 61 is provided to be annular along an outer edge of the light receiving section 13.

### (Third Modification Example)

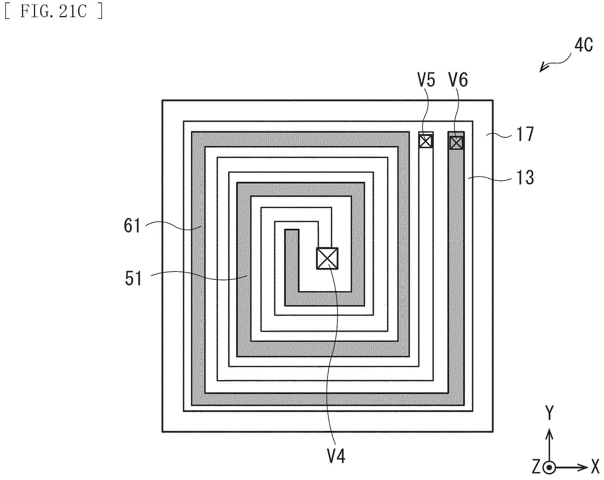

FIG. 21C schematically illustrates an example of a planar layout of a photodetection device 4C as a third modification example of the fourth embodiment of the present disclosure. The photodetection device 4C includes the one electrode body 61 having a planar shape that are wound spirally and the one resistor element 51 having a planar shape that are wound spirally. In the photodetection device 4C, a plurality of wound portions of the electrode body 61 is disposed in gaps between a plurality of wound portions of the resistor element 51.

### <5. Fifth Embodiment>

### [5-0. History]

In general, there is a demand for improved performance and downsizing of an electronic device such as a sensor or electronic equipment including the electronic device. The photodetection devicees described so far are no exception. In the photodetection devicees described in some embodiments described above, for example, although the resistor element is embedded, in order to cope with further miniaturization of each pixel to achieve high resolution, it is desirable to achieve high integration while improving a resistance value of the resistor element.

Under these circumstances, the present applicant has come to provide the semiconductor device having a resistor element that allows for the high integration, and a method of manufacturing the semiconductor device.

### [5-1. Configuration]

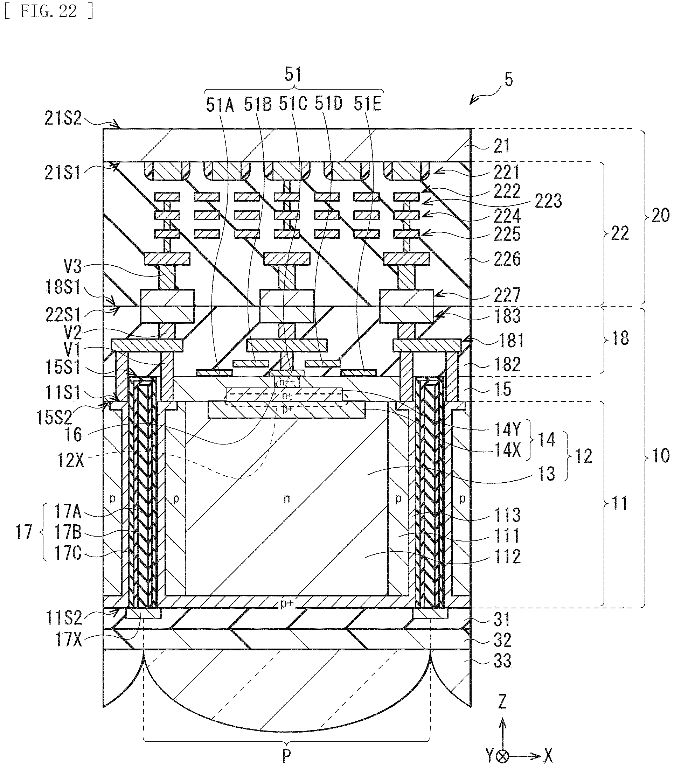

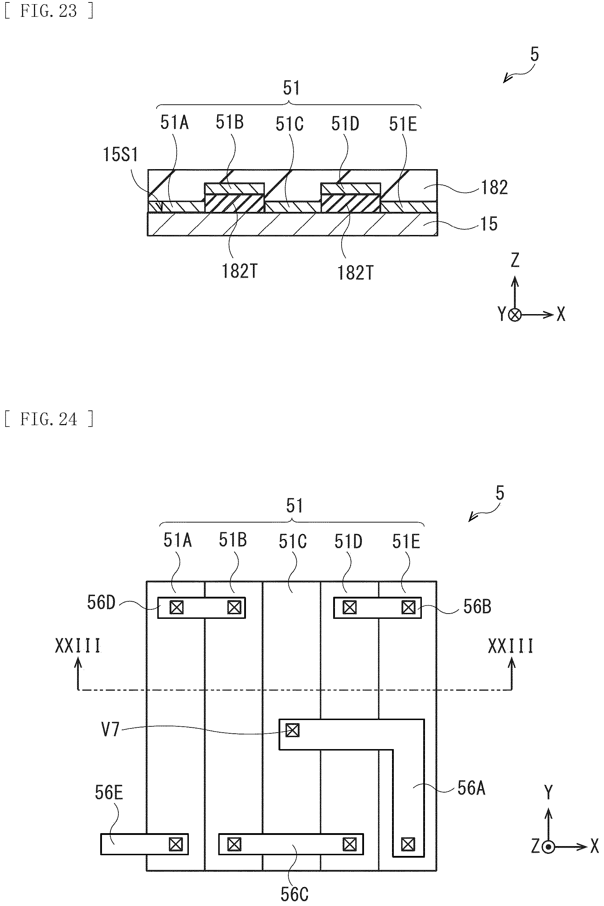

FIG. 22 schematically illustrates an example of a cross-sectional configuration of a photodetection device 5 according to a fifth embodiment of the present disclosure. FIG. 23 is an enlarged cross-sectional diagram illustrating an enlarged portion of the photodetection device 5 illustrated in FIG. 22.

In the photodetection device 5 illustrated in FIG. 22, a structure of the resistor element 51 differs from, for example, a structure of the photodetection device 2B illustrated in the second embodiment described above, or the like. A configuration the photodetection device 5 is substantially same as the configuration of the photodetection device 2B (FIG. 12) except for the above point.

In the photodetection device 5, the resistor element 51 has the resistance portions 51A to 51E. As illustrated in FIG. 23, the resistance portions 51A, 51C, and 51E are provided at mutually different height positions in the Z-axis direction from height positions of the resistance portions 51B and 51D. Specifically, the resistance portions 51A, 51C, and 51E are formed on the first surface 15S1 of the semiconductor layer 15. In contrast to this, the resistance portions 51B and 51D are formed on a protruded portion 182T that constitutes a part of the insulating layer 182. The protruded portion 182T is provided between the resistance portion 51A and the resistance portion 51C, and between the resistance portion 51C and the resistance portion 51E, in the X-axis direction. In the X-axis direction, the resistance portion 51B is provided between the resistance portion 51A and the resistance portion 51C, and the resistance portion 51D is provided between the resistance portion 51C and the resistance portion 51E.

FIG. 24 illustrates a configuration example of a planar layout of the resistor element 51. The resistance portions 51A to 51E have each a rectangular planar shape extending in the Y-axis direction. The resistance portions 51A to 51E are placed over without a gap in the X-axis direction in a planar view. As illustrated in FIG. 23, however, because the resistance portions 51A, 51C, and 51E are provided at the mutually different height positions from the resistance portions 51B and 51D in the Z-axis direction, the resistance portions 51A, 51C, and 51E are spaced apart from the resistance portions 51B and 51D, without being in direct contact with each other. However, the resistance portions 51A to 51E are coupled in series by the coupling portions 56A to 56D. The coupling portion 56A connects the resistance portion 51C and the resistance portion 51E. The coupling portion 56B connects the resistance portion 51E and the resistance portion 51D. The coupling portion 56C connects the resistance portion 51D and the resistance portion 51B. The coupling portion 56D connects the resistance portion 51B and the resistance portion 51A. Therefore, the resistance portions 51A to 51E are integrated as the resistor element 51. At an end of the resistance portion 51A on opposite side to the coupling portion 56D is provided the coupling portion 56E. The resistance portion 51A is coupled to the readout circuit 75 via the coupling portion 56E. It is desirable that thicknesses of the resistance portions 51A to 51E be constant in the XY plane and be equal to each other.

### [5-2. Method of Manufacturing]

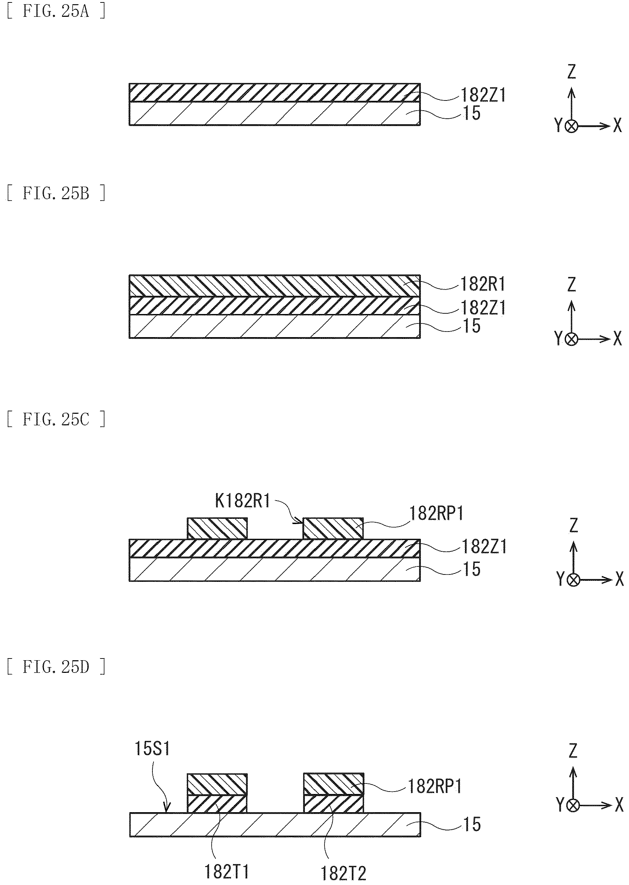

In the following, a description will be given of a method of manufacturing the resistor element 51 of the photodetection device 5 of the present embodiment, with reference to FIGs. 25A to 25I. Each of FIGs. 25A to 25I is a schematic diagram of a laminated cross section, illustrating one process of the method of manufacturing the resistor element 51 of the photodetection device 5.

First, as illustrated in FIG. 25A, an insulating film 182Z1 is formed on the semiconductor layer 15.

Next, as illustrated in FIG. 25B, a resist layer 182R1 is formed on the insulating film 182Z1.

Next, as illustrated in FIG. 25C, a resist pattern 182RP1 having an opening K182R1 at a predetermined position is formed by the photolithography method.

Next, as illustrated in FIG. 25D, etching processing that uses the resist pattern 182RP1 as a mask is performed to selectively remove an exposed portion of the insulating film 182Z1 not being covered with the resist pattern 182RP1, that is, a portion corresponding to the opening K182R1. This forms the plurality of protruded portions 182T. At this time, the first surface 15S1 of the semiconductor layer 15 is exposed in gaps of the plurality of protruded portions 182T.

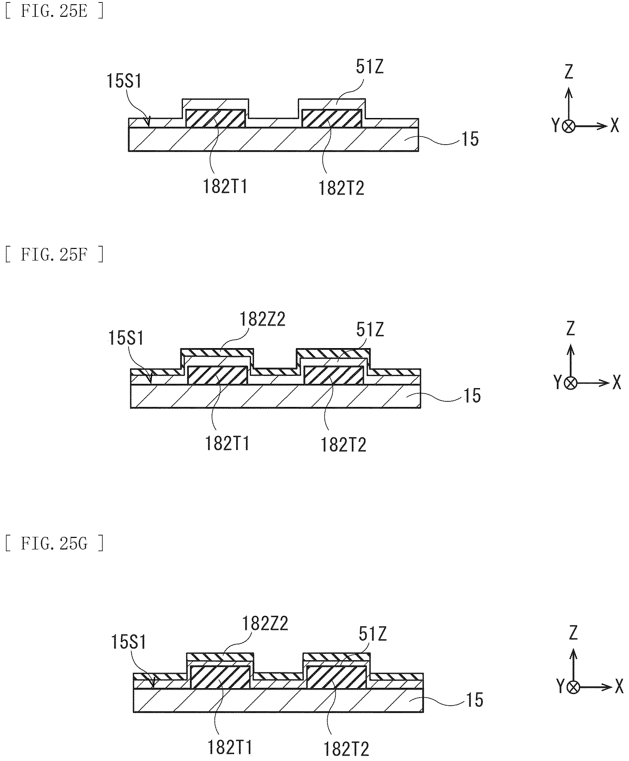

Next, after the resist pattern 182RP1 is removed, as illustrated in FIG. 25E, a resistance film 51Z is formed so as to cover the plurality of protruded portions 182T and the entire first surface 15S1 being exposed. The resistance film 51Z is formed by, for example, the CVD (chemical vapor deposition) method or the PVD (Physical Vapor Deposition) method, etc., using, for example, a polycrystalline semiconductor material such as polysilicon. In forming the resistance film 51Z, a portion of the resistance film 51Z covering a side surface of the protruded portion 182T is made relatively thinner than a portion of the resistance film 51Z that covers an upper surface of the protruded portion 182T of the resistance film 51Z and the first surface 15S1 of the semiconductor layer.

Next, as illustrated in FIG. 25F, an insulating film 182Z2 is formed to entirely cover the resistance film 51Z.

Next, as illustrated in FIG. 25G, the portion of the insulating film 182Z2 covering the side surface of the protruded portion 182T is removed by isotropic etching.

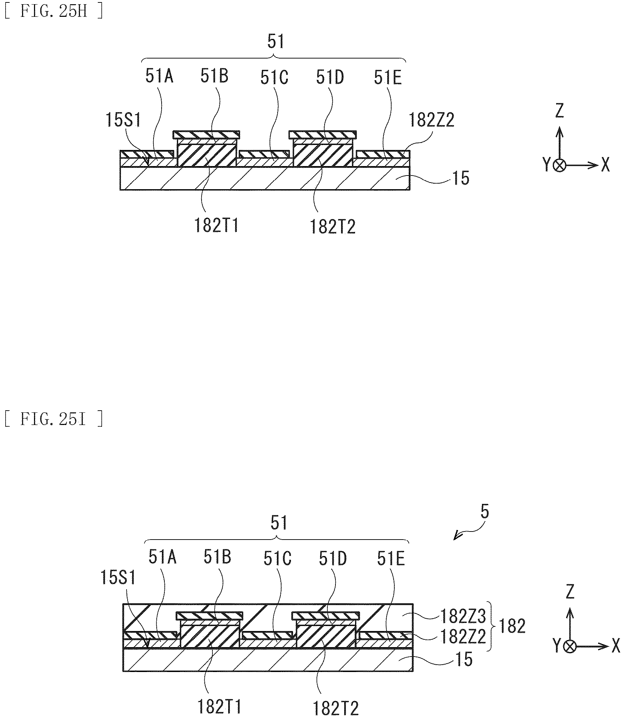

Next, as illustrated in FIG. 25H, the portion of the resistance film 51Z covering the side surface of the protruded portion 182T is removed. As a result, the resistance film 51Z is separated into the resistance portions 51A to 51E. That is, the resistance portions 51A, 51C, and 51E are formed in a self-aligned manner so as to correspond with widths W1, W3, and W5, respectively, of regions where the first surface 15S1 is exposed with no protruded portions 182T. In contrast, the resistance portions 51B and 51D are formed in a self-aligned manner so as to correspond with widths W2 and W4, respectively, of protruded potions 182T1 and 182T2. Therefore, a sum of the widths W1 to W5 of the resistance portions 51A to 51E matches a width W51 of the regions occupied by the resistor element 51.

Subsequently, as illustrated in FIG. 25I, the insulating layer 182 is obtained by forming an insulating layer 182Z3 to cover the whole. Then, by forming a via V7 and the coupling portions 56A to 56E, or the like, the resistor element 51 including the resistance portions 51A to 51E connected to each other is completed.

### [5-3. Effects/Workings]

In this manner, according to the photodetection device 5 of the present embodiment, the resistor element 51 is such that the resistance portions mutually adjacent to each other in the X-axis direction are formed at the different height positions. This makes it possible to arrange the plurality of resistance portions 51A to 51E without gaps in the X direction. As a result, it is possible to form more resistance portions in a region with a fixed area. That is, it is possible to further increase a resistance value of the resistor element 51 formed in the region with the fixed area. Therefore, according to the photodetection device 5, it is possible to cope with even higher integration.

In addition, the resistor element 51 has a structure that makes it possible to collectively form the plurality of resistance portions 51A to 51E that constitutes the resistor element 51. Consequently, efficiency of manufacturing is higher than, for example, a case where the plurality of resistance portions 51A to 51E is individually formed, and it is possible to suppress variations in film thicknesses and variations in film quality of the plurality of resistance portions 51A to 51E. Furthermore, although the respective widths of the resistance portions 51A to 51E (dimensions in the X-axis direction) differ from each other, it is possible to make variations in the resistance value of the entire resistor element 51 smaller by keeping the sum width of the resistance portions 51A to 51E constant.

### [5-4. Modification Examples]

### (First Modification Example)

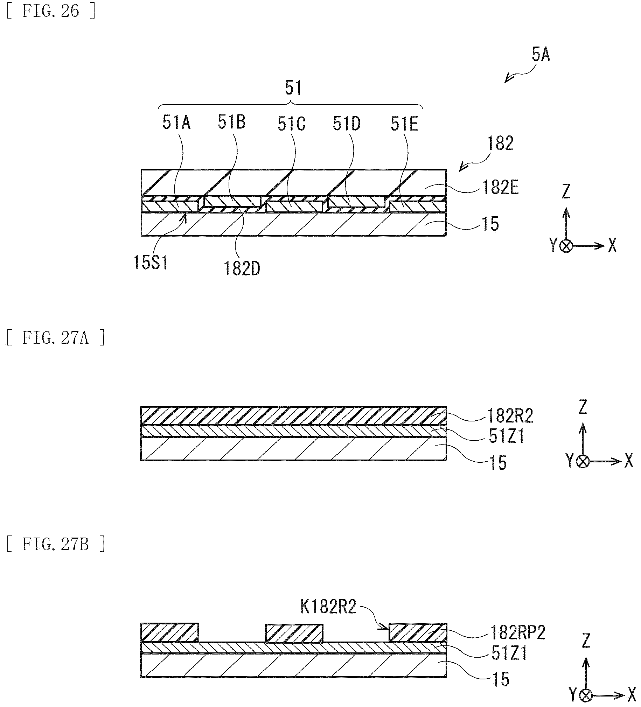

FIG. 26 is an enlarged cross-sectional diagram illustrating an enlarged portion of a photodetection device 5A as a first modification example according to the fifth embodiment of the present disclosure. As illustrated in FIG. 26, in the photodetection device 5A, the resistor element 51 includes the resistance portions 51A to 51B. The resistance portions 51A to 51E are provided at a level between the semiconductor layer 15 and the insulating layer 182E that constitutes some of the insulating layer 182, and each extend in the Y-axis direction, similarly to the photodetection device 5. The resistance portions 51A, 51C, and 51E are provided at the mutually different height positions from the resistance portions 51B and 51D in the Z-axis direction. Specifically, the resistance portions 51A, 51C, and 51E are formed on the first surface 15S1 of the semiconductor layer 15. In contrast, the resistance portions 51B and 51D are formed on an insulating layer 182D that constitutes a portion of the insulating layer 182. Therefore, the resistance portions 51B and 51D are spaced from the first surface 15S1 of the semiconductor layer 15 by the thickness of the insulating layer 182D. That is, the height positions on the lower surfaces of the resistance portions 51A, 51C, and 51E are offset from the height positions on the lower surfaces of the resistance portions 51B and 51D by the thickness of the insulating layer 182D. The insulating layer 182D is provided to fill the gaps between the resistance potions 51A to 51E. It is desirable that the thicknesses of the resistance portions 51A to 51E be constant in the XY plane and be equal to each other.

In the resistor element 51 of the photodetection device 5A as this modification example, the gap by the thickness of the insulating layer 182D is generated between adjacent resistance portions in the X-axis direction. However, the resistance portions 51A to 51E are formed at a substantially same level to each other. That is, the resistance portions 51A to 51E are provided at positions where at least a portion of each of the resistance portions 51A to 51E overlaps each other in a level between the semiconductor layer 15 and the insulating layer 182E. Consequently, in the photodetection device 5A, the thickness of the resistor element 51 is made thinner than the photodetection device 5. Therefore, an aspect of the photodetection device 5A is more suitable for a case where the thickness is further reduced.

In the following, a description will be given of a method of manufacturing the resistor element 51 of the photodetection device 5A of the present embodiment with reference to FIG. 27A to FIG. 27F. Each of FIGs. 27A to 27F is a schematic diagram of a laminated cross section, illustrating one process of the method of manufacturing the resistor element 51 of the photodetection device 5A.

First, as illustrated in FIG. 27A, a resistance film 51Z1 is formed entirely on the semiconductor layer 15. The resistance film 51Z1 is formed by, for example, the CVD (chemical vapor deposition) method or the PVD (Physical Vapor Deposition) method, using, for example, a polycrystalline semiconductor material such as polysilicon. Thereafter, the resist layer 182R1 is formed entirely on the resistance film 51Z1.

Next, as illustrated in FIG. 27B, a resist pattern 182RP2 having an opening K182R2 at a predetermined position is formed by the photolithography method.

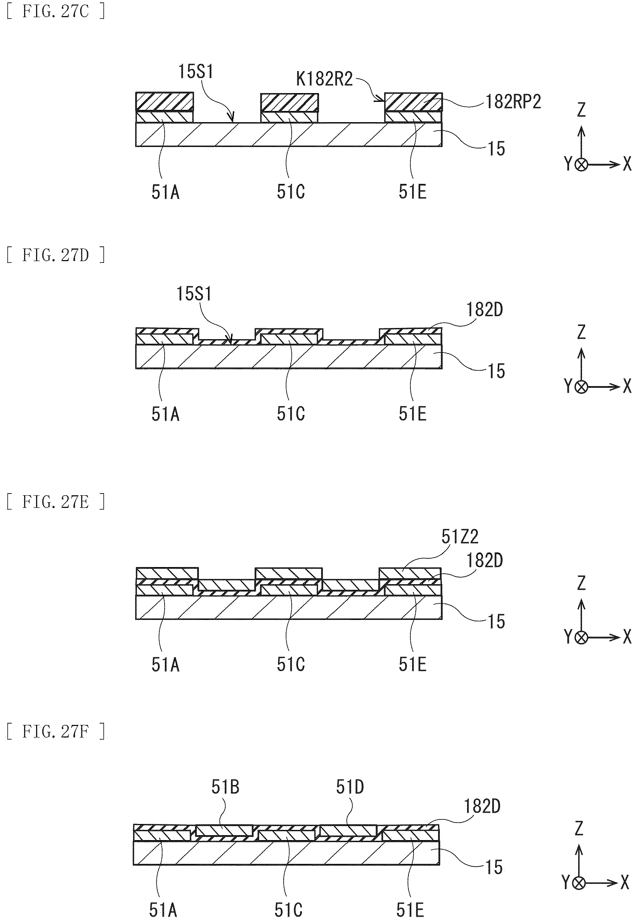

Next, as illustrated in FIG. 27C, etching process that uses the resist pattern 182RP2 as a mask is performed to selectively remove an exposed portion of the resistance film 51Z1 not being covered with the resist pattern 182RP2, that is, a portion corresponding to the opening K182R2. This forms the resistance portions 51A, 51C, and 51E. At this time, the first surface 15S1 of the semiconductor layer 15 is exposed in the gaps of the resistance portions 51A, 51C, and 51E.

Next, after the resist pattern 182RP2 is removed, as illustrated in FIG. 27D, the insulating film 182D is formed to entirely cover the resistance portions 51A, 51C, and 51E, and the first surface 15S1 of the semiconductor layer 15.

Next, as illustrated in FIG. 27E, a resistance film 51Z2 is formed to entirely cover the insulating film 182D.

Next, as illustrated in FIG. 27F, the entire surface is polished by CMP, or the like, by removing a protruded portion of the resistance film 51Z2 until the insulating film 182D covering the resistance portions 51A, 51C, and 51E is exposed. As a result, the resistance portion 51B is formed between the resistance portion 51A and the resistance portion 51C, and the resistance portion 51D is formed between the resistance portion 51C and the resistance portion 51E.

Lastly, the insulating layer 182 is obtained by forming the insulating layer 182E so as to cover the whole. Then, by forming a via and coupling portions, or the like, the resistor element 51 including the resistance portions 51A to 51E connected to each other is completed.

In the photodetection device 5A of this modification example as well, it is possible to cope with the even higher integration.

### (Second Modification Example)

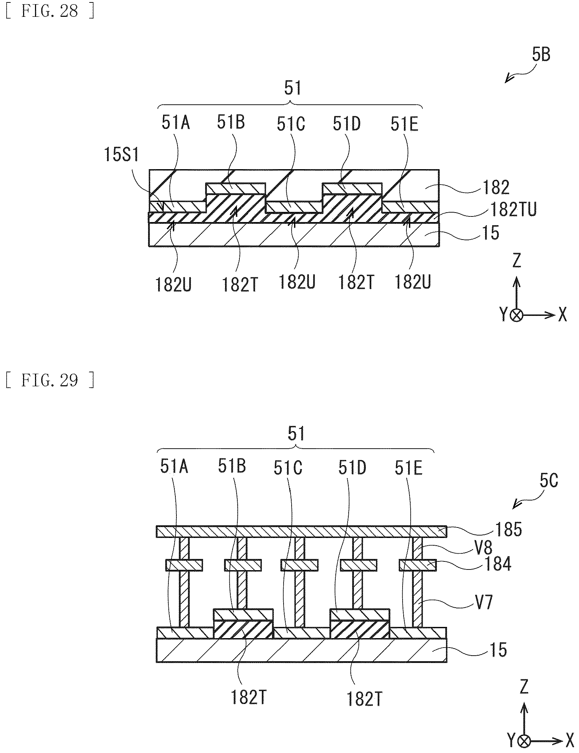

FIG. 28 is an enlarged cross-sectional diagram illustrating an enlarged portion of a photodetection device 5B as a second modification example according to the fifth embodiment of the present disclosure. In the photodetection device 5B, a recess-protrusion structure 182TU alternately having the protruded portions 182T and recessed portions 182U is provided on the first surface 15S1 of the semiconductor layer 15. In the photodetection device 5B, the resistance portions 51A, 51C, and 51E are provided in the recess portion 182U, and the resistance portions 51B and 51D are provided on the protruded portion 182T. According to the photodetection device 5B of this modification example, because the resistance portions 51A to 51E are provided in the recess-protrusion structure 182TU, the resistance portions 51A to 51E are held in the recess-protrusion structure 182TU more stably as compared to the photodetection devicees 5 and 5A, or the like.

### (Third Modification Example)

FIG. 29 is an enlarged cross-sectional diagram illustrating an enlarged portion of a photodetection device 5C as a third modification example according to the fifth embodiment of the present disclosure. In the photodetection device 5C, each of the resistance portions 51A to 51E is coupled to a wiring layer 184 via the via V7 and is further coupled to a wiring layer 185 via a via V8. It is possible to form a structure with higher resistance, the structure including the resistor element 51, the vias V7 and V8, and the wiring layers 184 and 185, by the vias V7 and V8 as well as the wiring layers 184 and 185 each including predetermined resistant materials.

### (Fourth Modification Example)

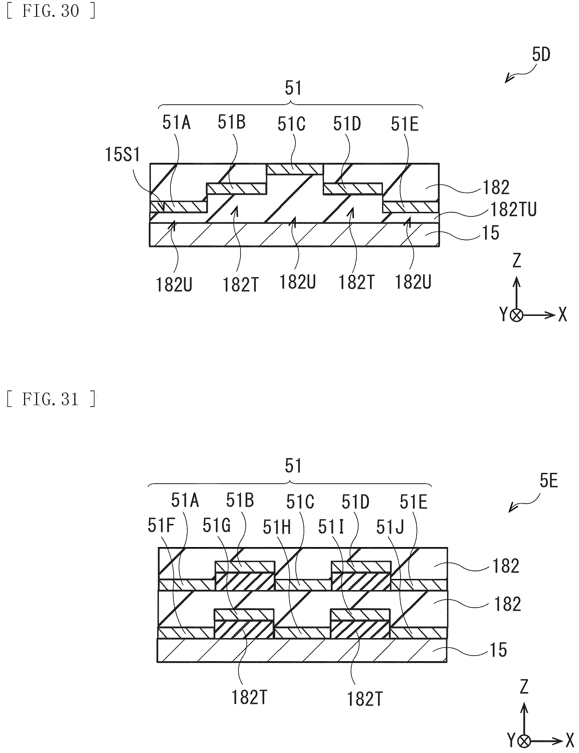

FIG. 30 is an enlarged cross-sectional diagram illustrating an enlarged portion of a photodetection device 5D as a fourth modification example according to the fifth embodiment of the present disclosure. In the photodetection device 5D, the resistance portions 51A to 51E are provided on height positions on three different stages. Specifically, in the Z-axis direction, the resistance portions 51A and 51E are provided at the lowest positions, the resistance portion 51C is provided at the highest position, and the resistance portion 51B and 51D are provided at intermediate height positions between the highest and lowest positions.

### (Fifth Modification Example)

FIG. 31 is an enlarged cross-sectional diagram illustrating an enlarged portion of a photodetection device 5E as a fifth modification example according to the fifth embodiment of the present disclosure. In the photodetection device 5E, the resistor element 51 has a two-layer structure. Specifically, resistance portions 51F to 51J are formed on a first layer, and the resistance portions 51A to 51E are formed on a second layer. The resistance portions 51F to 51J and the resistance portions 51A to 51E are coupled in series to each other and constitute one resistor element 51.

### (Sixth Modification Example)

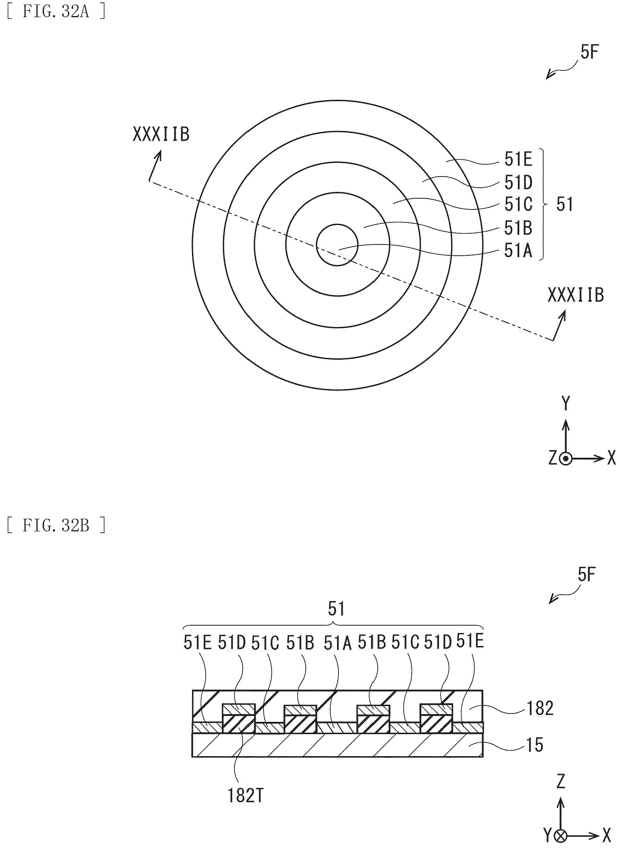

Although the photodetection device 5 has a rectangular planar shape in which each of the resistance portions 51A to 51E extends in one direction, the present disclosure is not limited to this. FIGs. 32A and 32B are a plan view and a cross-sectional view schematically illustrating the resistor element 51 that constitutes a photodetection device 5F as a sixth modification example according to the fifth embodiment of the present disclosure. In the photodetection device 5F, the resistance portions 51B to 51E that constitute the resistor element 51 are in an annular pattern, each having circular outer edge and inner edges, and are disposed in a concentric shape with the resistance portion 51A as a center.

### (Seventh Modification Example)

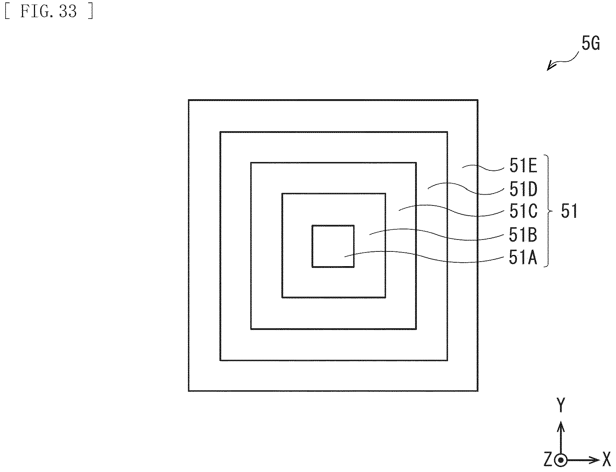

FIG. 33 is a plan view schematically illustrating the resistor element 51 that constitutes a photodetection device 5G as a seventh modification example of the fifth embodiment of the present disclosure. In the photodetection device 5G, the resistance portions 51B to 51E that constitute the resistor element 51 are in an annular pattern, each having rectangular outer edge and inner edges, and are disposed in the concentric shape with the resistance portion 51A as a center.

### <6. Application Examples>

FIG. 34 illustrates an example of a schematic configuration of a distance imaging apparatus 1000 as electronic equipment including the photodetection device (for example, the photodetection device 1) of the present disclosure. The distance imaging apparatus 1000 is a specific example corresponding to a "ranging apparatus" of the present disclosure.

The distance imaging apparatus 1000 includes, for example, a light source apparatus 1100, an optical system 1200, the photodetection device 1, an image processing circuit 1300, a monitor 1400, and a memory 1500.

It is possible for the distance imaging apparatus 1000 to obtain a distance image according to a distance to an irradiation object 2000, by receiving light (modulated light or pulsed light) projected from the light source apparatus 1100 toward the irradiation object 2000 and reflected on a surface of the irradiation object 2000.

The optical system 1200 includes one or more lenses, guides image light (entering light) from the irradiation object 2000 to the photodetection device 1, and produces an image on the light receiving surface (sensor section) of the photodetection device 1.

The image processing circuit 1300 performs image processing that constructs a distance image on the basis of a distance signal supplied from the photodetection device 1. The distance image (image data) obtained from the image processing is supplied to and displayed on the monitor 1400, or is supplied to and stored (recorded) in the memory 1500.

In the distance imaging apparatus 1000 thus configured, application of the photodetection device described above (for example, the photodetection device 1) makes it possible to compute a distance to the irradiation object 2000 only on the basis of a light reception signal from a highly stable unit pixel P and to generate a highly accurate distance image. That is, it is possible for the distance imaging apparatus 1000 to obtain more accurate distance images.

### <7. Applications>

### (Applications to Mobile Objects>

It is possible to apply the techniques according to the present disclosure to various products. For example, the techniques according to the present disclosure may be realized as an apparatus to be mounted on any kind of mobile object including automobiles, electric vehicles, hybrid electric vehicles, motorcycles, bicycles, personal mobilities, airplanes, drones, ships, robots, construction machinery, or agricultural machinery (tractors).

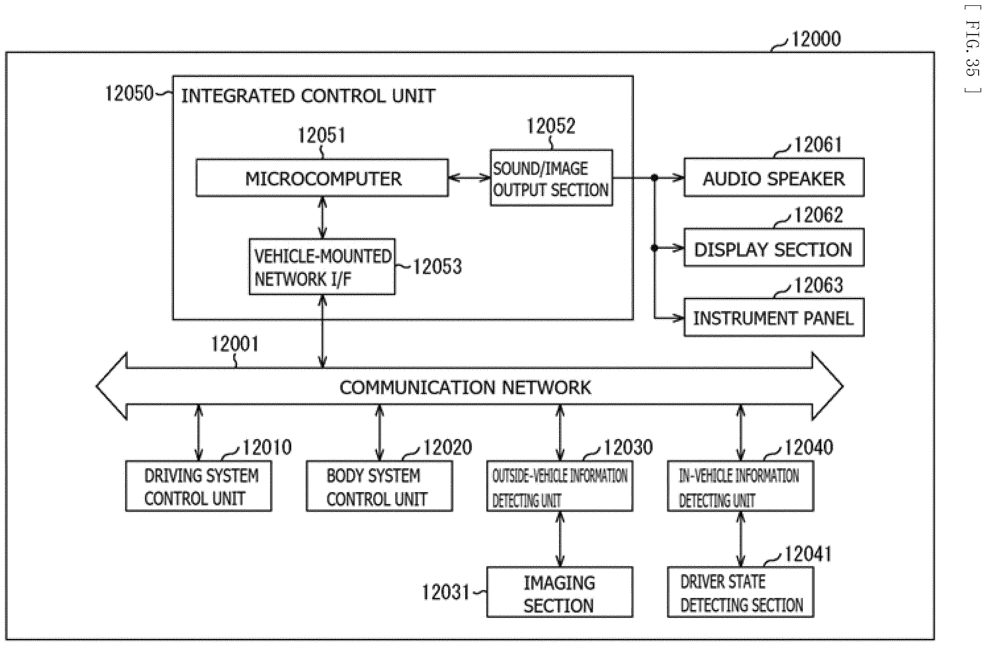

FIG. 35 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 35, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 35, an audio speaker 12061, a display section 12062, and an instrument panel 12063 are illustrated as the output device. The display section 12062 may, for example, include at least one of an on-board display and a head-up display.

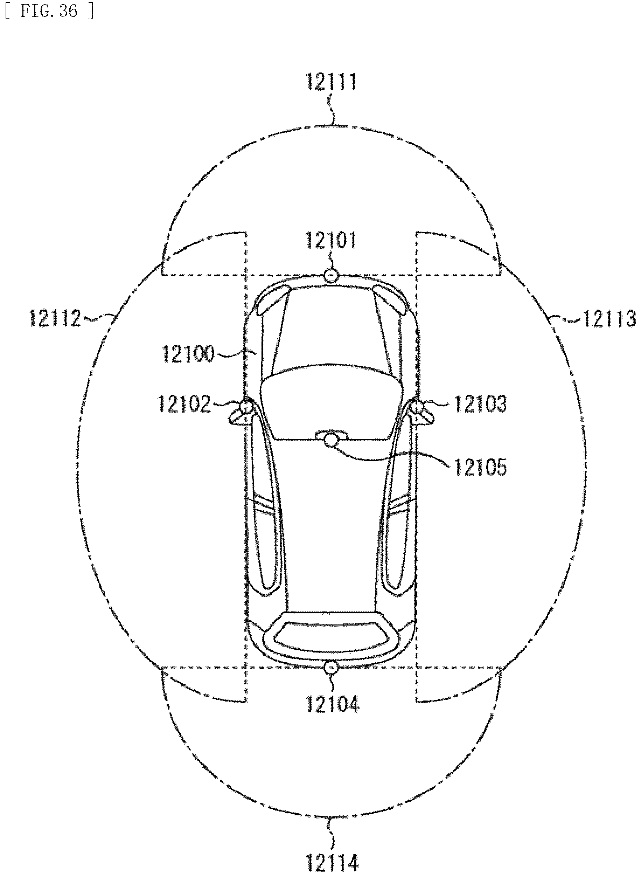

FIG. 36 is a diagram depicting an example of the installation position of the imaging section 12031.

In FIG. 36, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 36 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

As above, although a description has been given with reference to some embodiments and modification examples, as well as application examples and applications, content of the present disclosure is not limited to the above embodiments, or the like, and various modifications are possible. For example, it is not necessary that the photodetection device of the present disclosure includes all of the components described in the above embodiments, or the like, and may include another layer to the contrary.

For example, in some of the above embodiments, although polysilicon is exemplified as a polycrystalline semiconductor that constitutes the resistor element, a resistor may include a polycrystalline semiconductor other than this in the present disclosure.

In addition, for example, in the first embodiment described above, both of the main body section 52 and the take-out section 53 of the resistor element 51 include a polycrystalline semiconductor, the present disclosure is not limited to this. In the present disclosure, for example, a portion or all of the main body section 52 may be replaced with a cermet resistor or a portion of the take-out section 53 may be replaced with a cermet resistor. However, a portion of the take-out portion 53 that constitutes the first coupling section C1 coupled to the contact layer 16 may be formed of a polycrystalline semiconductor.

In addition, in the photodetection device 1 of the first embodiment described above, or the like, the p-type semiconductor region (p+) 113 that is the anode on the first surface 11S1 of the semiconductor substrate 11 is coupled to the via V1 to ensure a conductive path between the anode and the outside by using the wiring layer 181, or the like. In the present disclosure, however, coupling to the p-type semiconductor region (p+)) 113 that is, for example, the anode may be made on the second surface 11S2 of the semiconductor substrate 11.

In addition, the polarity of the semiconductor region that constitutes the photodetection device of the present disclosure may be inverted. Moreover, the photodetection device of the present disclosure may have holes as signal charges.

Furthermore, in a state in which application of a reverse bias between an anode and a cathode causes avalanche multiplication, potentials of the anode and the cathode of the photodetection device of the present disclosure are not limited.

In addition, in the above embodiments or the like, although the example is illustrated in which silicon is used as the semiconductor substrate 11 and the semiconductor layer 15, germanium (Ge) or a compound semiconductor of silicon (Si) and germanium (Ge) (for example, silicon germanium (SiGe)) may be used for the semiconductor substrate 11 and the semiconductor layer 15.

It is to be noted that the effects described in the above embodiments, or he like, are merely examples and may be other effects or may further include other effects.

In the photodetection device according to one embodiment of the present disclosure, the resistor including a polycrystalline semiconductor material is coupled to the first electrode that is electrically coupled to the multiplier, for example. Therefore, the structural stability of the semiconductor substrate is improved more than a case in which the resistor includes a metallic material. That is, because it is possible to suppress occurrence of crystal structure defects in the semiconductor substrate 11, it is possible to obtain the high reliability of the semiconductor substrate 11 such as ensuring the sufficient dielectric strength voltage.

It is to be noted that the present disclosure may have the following configurations:
(1) A photodetection device including:
   a semiconductor substrate having a first surface and a second surface facing each other, and including a pixel array section in which a plurality of pixels is disposed in an array in an in-plane direction;
   a light receiving section provided inside the semiconductor substrate for each of the pixels, and generating carriers according to quantities of received light, by photoelectric conversion;
   a multiplier provided on the first surface of the semiconductor substrate for each of the pixels, having a laminated structure of a first conductivity type region and a second conductivity type region, and avalanche-multiplying the carriers generated in the light receiving section;
   a first electrode electrically coupled to the multiplier;
   a second electrode electrically coupled to the light receiving section; and
   a resistor including a polycrystalline semiconductor material and provided to be in contact with the first electrode, while facing the first surface.
(2) The photodetection device according to (1) further including:
   a first wiring line electrically coupled to the resistor, in which
   a position of a first coupling section between the resistor and the first electrode and a position of a second coupling section between the resistor and the wiring line are different from each other in a plane parallel to the first surface.
(3) The photodetection device according to (2), in which
   the first coupling section is located in a middle region of the pixel in the plane parallel to the first surface, and
   the second coupling section is located in a peripheral region of the pixel in the plane parallel to the first surface.
(4) The photodetection device according to any one of (1) to (3), in which
   the resistor includes a main body section extending parallel to the first surface and a take-out section connecting the main body section and the first electrode.
(5) The photodetection device according to (4), in which the main body section so extends that a traveling direction varies at least one or more locations from a middle region of the pixel toward a peripheral region of the pixel in a plane parallel to the first surface.
(6) The photodetection device according to (4), in which
   the main body section extends spirally from a middle region of the pixel to a peripheral region of the pixel in a plane parallel to the first surface.
(7) The photodetection device according to (4), further including:
   a plurality of first reflection layers that are disposed discretely along the first surface at a same level as the main body section.
(8) The photodetection device according to (7), in which the polycrystalline semiconductor material and the plurality of first reflection layers include a same kind of material.
(9) The photodetection device according to (7) or (8), further including:
   a plurality of second reflection layers that is provided at a different level from the level in which the plurality of first reflection layers is provided and is provided at a position corresponding to gaps of the plurality of first reflection layers in a thickness direction orthogonal to the first surface, and that is disposed discretely along the first surface, in which
   the resistor and the plurality of first reflection layers both include polysilicon, and
   the plurality of second reflection layers includes SiO2.
(10) The photodetection device according to (9), in which
   the plurality of first reflection layers and the plurality of second reflection layers are each arrayed two-dimensionally and periodically along the first surface.
(11) The photodetection device according to (4), further including:
   a plurality of reflection layers disposed discretely along the first surface, at a level between the main body section and the first electrode, wherein
   the main body section and a portion of the plurality of reflection layers overlap each other in a thickness direction orthogonal to the first surface.
(12) The photodetection device according to (11), in which
   one of the plurality of reflection layers electrically couples the main body section and the first electrode.
(13) The photodetection device according to (11) or (12), in which
   the resistor element and the plurality of reflection layers include a same kind of material.
(14) The photodetection device according to any one of (1) to (13), in which
   the polycrystalline semiconductor material is polysilicon.
(15) The photodetection device according to any one of (1) to (14), in which
   the first electrode includes a first conductivity type semiconductor including a first conductivity type impurity element, and
   the resistor includes the first conductivity type impurity element.
(16) The photodetection device according to any one of (1) to (15), in which
   the resistor has a resistance value of 5 kQ or higher.
(17) The photodetection device according to any one of (1) to (16), in which
   the resistor includes polysilicon having impurity concentration of 1019 atoms/cm3 or higher and less than 1021 atoms/cm3.
(18) The photodetection device according to any one of (1) to (17), further including:
   a second wiring line electrically coupled to the second electrode, in which
   the second wiring line is provided to surround a region corresponding to the light receiving section in a cross section parallel to the first surface.
(19) The photodetection device according to (18), further including:
   a pixel separator that is provided inside the semiconductor substrate and surround the light receiving section in a cross section parallel to the first surface, and separates the plurality of pixels.
(20) The photodetection device according to (19), further including:
   a third wiring line that is provided to overlap the pixel separator in a thickness direction orthogonal to the first surface and to form a grid shape in a cross section parallel to the first surface, and is electrically coupled to the second wiring line.
(21) The photodetection device according to (20), in which
   the second wiring line and the third wiring line both include the polycrystalline semiconductor material.
(22) The photodetection device according to (21), in which
   the polycrystalline semiconductor material is polysilicon.
(23) The photodetection device according to (20), in which
   the second wiring line includes the polycrystalline semiconductor material, and
   the third wiring line includes a single-layer tungsten film, or a laminated body including a tungsten silicon layer and a tungsten layer.
(24) The photodetection device according to (20), in which
   the resistor includes a main body section extending parallel to the first surface and a take-out section connecting the main body section and the first electrode,
   the second wiring line and the take-out section include the polycrystalline semiconductor material; and
   the third wiring line and the main body section include a laminated body of a tungsten silicon layer and a tungsten layer.
(25) The photodetection device according to (1), further including:
   a fourth wiring line provided on a side opposite to the semiconductor substrate when viewed from the resistor; and
   an insulating film provided between the resistor and the first electrode, in which
   the resistor and the first electrode are electrically coupled via the fourth wiring line.
(26) The photodetection device according to (25), in which
   the insulating film is an oxide film having relative permittivity ε of 4.2 and a thickness larger than 150 nm.
(27) The photodetection device according to (25) or (26), in which
   the resistor includes two or more resistor layers provided at mutually different levels.
(28) A photodetection device including:
   a semiconductor substrate having a first surface and a second surface facing each other, and including a pixel array section in which a plurality of pixels is disposed in an array in an in-plane direction;
   a light receiving section provided inside the semiconductor substrate for each of the pixels, and generating carriers according to quantities of received light, by photoelectric conversion;
   a multiplier provided on the first surface of the semiconductor substrate for each of the pixels, having a laminated structure of a first conductivity type region and a second conductivity type region, and avalanche-multiplying the carriers generated in the light receiving section;
   a first electrode electrically coupled to the multiplier;
   a second electrode electrically coupled to the light receiving section;
   a resistor including a polycrystalline semiconductor material and provided to be in electrical conduction with the first electrode at a position facing the first surface; and
   an electrode body that is provided at a position facing the first surface and to which a voltage different from a voltage given to the resistor element is configured to be given.
(29) The photodetection device according to (28), in which
   a voltage to be given to the electrode body has a reverse polarity to a polarity of the voltage to be applied to the resistor element.
(30) The photodetection device according to (28) or (29), in which
   a gap between the electrode body and the first surface is narrower than a gap between the resistor element and the first surface.
(31) The photodetection device according to any one of (28) to (30), in which
   the resistor element and the electrode body include a substantially same constituent material.
(32) The photodetection device according to any one of (28) to (31), in which
   the resistor element and the electrode body extend in a substantially same direction.
(33) A semiconductor device that includes a resistor element, the resistor element including:
   one or more first resistance film portions located at a first height in a thickness direction; and
   one or more second resistance film portions that are located at a second height in the thickness direction and are adjacent to the first resistance film portions in a first direction orthogonal to the thickness direction, wherein
   the first resistance film portions and the second resistance film portions are spaced apart from each other.
(34) The semiconductor device according to (33), including:
   a plurality of the first resistance film portions and a plurality of the second resistance film portions that each extend in a second direction orthogonal to both the thickness direction and the first direction, in which
   the plurality of first resistance film portions and the plurality of second resistance film portions are alternately disposed in the first direction.
(35) A method of manufacturing a semiconductor device, the semiconductor device including a resistor element that includes
   one or more first resistance film portions located at a first height in a thickness direction, and
   one or more second resistance film portions that are located at a second height in the thickness direction and are adjacent to the first resistance film portions in a first direction orthogonal to the thickness direction,
   the method including:
      forming, on a semiconductor layer, an insulating film including an insulating material;
      forming, on the semiconductor layer, a protruded portion that includes the insulating material and includes an upper surface and a side surface, by selectively removing the insulating film;
      forming a resistance film including a resistant material to cover both the protruded portion and a portion of the semiconductor layer surrounding the protruded portion; and
      separating the first resistance film portion covering the upper surface of the protruded portion and the second resistance film portion covering the portion surrounding the protruded portion, by removing a portion of the resistance film covering the side surface of the protruded portion.

This application claims priority based on Japanese Patent Application No. 2022-023216 filed on February 17, 2022 with Japan Patent Office, the entire contents of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. A photodetection device comprising:
a semiconductor substrate having a first surface and a second surface facing each other, and including a pixel array section in which a plurality of pixels is disposed in an array in an in-plane direction;
a light receiving section provided inside the semiconductor substrate for each of the pixels, and generating carriers according to quantities of received light, by photoelectric conversion;
a multiplier provided on the first surface of the semiconductor substrate for each of the pixels, having a laminated structure of a first conductivity type region and a second conductivity type region, and avalanche-multiplying the carriers generated in the light receiving section;
a first electrode electrically coupled to the multiplier;
a second electrode electrically coupled to the light receiving section; and
a resistor including a polycrystalline semiconductor material and provided to be in contact with the first electrode, while facing the first surface.

2. The photodetection device according to claim 1 further comprising:
a first wiring line electrically coupled to the resistor, wherein
a position of a first coupling section between the resistor and the first electrode and a position of a second coupling section between the resistor and the wiring line are different from each other in a plane parallel to the first surface.

3. The photodetection device according to claim 2, wherein
the first coupling section is located in a middle region of the pixel in the plane parallel to the first surface, and
the second coupling section is located in a peripheral region of the pixel in the plane parallel to the first surface.

4. The photodetection device according to claim 1, wherein
the resistor includes a main body section extending parallel to the first surface and a take-out section connecting the main body section and the first electrode.

5. The photodetection device according to claim 4, wherein the main body section so extends that a traveling direction varies at least one or more locations from a middle region of the pixel toward a peripheral region of the pixel in a plane parallel to the first surface.

6. The photodetection device according to claim 4, wherein
the main body section extends spirally from a middle region of the pixel to a peripheral region of the pixel in a plane parallel to the first surface.

7. The photodetection device according to claim 4, further comprising:
a plurality of first reflection layers that are disposed discretely along the first surface at a same level as the main body section.

8. The photodetection device according to claim 7, wherein the polycrystalline semiconductor material and the plurality of first reflection layers include a same kind of material.

9. The photodetection device according to claim 7, further comprising:
a plurality of second reflection layers that is provided at a different level from the level in which the plurality of first reflection layers is provided and is provided at a position corresponding to gaps of the plurality of first reflection layers in a thickness direction orthogonal to the first surface, and that is disposed discretely along the first surface, wherein
the resistor and the plurality of first reflection layers both include polysilicon, and
the plurality of second reflection layers includes SiO2.

10. The photodetection device according to claim 9, wherein
the plurality of first reflection layers and the plurality of second reflection layers are each arrayed two-dimensionally and periodically along the first surface.

11. The photodetection device according to claim 4, further comprising:
a plurality of reflection layers disposed discretely along the first surface, at a level between the main body section and the first electrode, wherein
the main body section and a portion of the plurality of reflection layers overlap each other in a thickness direction orthogonal to the first surface.

12. The photodetection device according to claim 11, wherein
one of the plurality of reflection layers electrically couples the main body section and the first electrode.

13. The photodetection device according to claim 11, wherein
the resistor element and the plurality of reflection layers include a same kind of material.

14. The photodetection device according to claim 1, wherein
the polycrystalline semiconductor material comprises polysilicon.

15. The photodetection device according to claim 1, wherein
the first electrode includes a first conductivity type semiconductor including a first conductivity type impurity element, and
the resistor includes the first conductivity type impurity element.

16. The photodetection device according to claim 1, wherein
the resistor has a resistance value of 5 kΩ or higher.

17. The photodetection device according to claim 1, wherein
the resistor includes polysilicon having impurity concentration of 1019 atoms/cm3 or higher and less than 1021 atoms/cm3.

18. The photodetection device according to claim 1, further comprising:
a second wiring line electrically coupled to the second electrode, wherein
the second wiring line is provided to surround a region corresponding to the light receiving section in a cross section parallel to the first surface.

19. The photodetection device according to claim 18, further comprising:
a pixel separator that is provided inside the semiconductor substrate and surround the light receiving section in a cross section parallel to the first surface, and separates the plurality of pixels.

20. The photodetection device according to claim 19, further including:
a third wiring line that is provided to overlap the pixel separator in a thickness direction orthogonal to the first surface and to form a grid shape in a cross section parallel to the first surface, and is electrically coupled to the second wiring line.

21. The photodetection device according to claim 20, wherein
the second wiring line and the third wiring line both include the polycrystalline semiconductor material.

22. The photodetection device according to claim 21, wherein
the polycrystalline semiconductor material comprises polysilicon.

23. The photodetection device according to claim 20, wherein
the second wiring line includes the polycrystalline semiconductor material, and
the third wiring line includes a single-layer tungsten film, or a laminated body including a tungsten silicon layer and a tungsten layer.

24. The photodetection device according to claim 20, wherein
the resistor includes a main body section extending parallel to the first surface and a take-out section connecting the main body section and the first electrode,
the second wiring line and the take-out section include the polycrystalline semiconductor material; and
the third wiring line and the main body section include a laminated body of a tungsten silicon layer and a tungsten layer.

25. The photodetection device according to claim 1, further comprising:
a fourth wiring line provided on a side opposite to the semiconductor substrate when viewed from the resistor; and
an insulating film provided between the resistor and the first electrode, wherein
the resistor and the first electrode are electrically coupled via the fourth wiring line.

26. The photodetection device according to claim 25, wherein
the insulating film comprises an oxide film having relative permittivity ε of 4.2 and a thickness larger than 150 nm.

27. The photodetection device according to claim 25, wherein
the resistor includes two or more resistor layers provided at mutually different levels.

28. A photodetection device comprising:
a semiconductor substrate having a first surface and a second surface facing each other, and including a pixel array section in which a plurality of pixels is disposed in an array in an in-plane direction;
a light receiving section provided inside the semiconductor substrate for each of the pixels, and generating carriers according to quantities of received light, by photoelectric conversion;
a multiplier provided on the first surface of the semiconductor substrate for each of the pixels, having a laminated structure of a first conductivity type region and a second conductivity type region, and avalanche-multiplying the carriers generated in the light receiving section;
a first electrode electrically coupled to the multiplier;
a second electrode electrically coupled to the light receiving section;
a resistor including a polycrystalline semiconductor material and provided to be in electrical conduction with the first electrode at a position facing the first surface; and
an electrode body that is provided at a position facing the first surface and to which a voltage different from a voltage given to the resistor element is configured to be given.

29. The photodetection device according to claim 28, wherein
a voltage to be given to the electrode body has a reverse polarity to a polarity of the voltage to be applied to the resistor element.

30. The photodetection device according to claim 28, wherein
a gap between the electrode body and the first surface is narrower than a gap between the resistor element and the first surface.

31. The photodetection device according to claim 28, wherein
the resistor element and the electrode body include a substantially same constituent material.

32. The photodetection device according to claim 28, wherein
the resistor element and the electrode body extend in a substantially same direction.

33. A semiconductor device that includes a resistor element, the resistor element comprising:
one or more first resistance film portions located at a first height in a thickness direction; and
one or more second resistance film portions that are located at a second height in the thickness direction and are adjacent to the first resistance film portions in a first direction orthogonal to the thickness direction, wherein
the first resistance film portions and the second resistance film portions are spaced apart from each other.

34. The semiconductor device according to claim 33, further comprising:
a plurality of the first resistance film portions and a plurality of the second resistance film portions that each extend in a second direction orthogonal to both the thickness direction and the first direction, wherein
the plurality of first resistance film portions and the plurality of second resistance film portions are alternately disposed in the first direction.

35. A method of manufacturing a semiconductor device, the semiconductor device including a resistor element that includes
one or more first resistance film portions located at a first height in a thickness direction, and
one or more second resistance film portions that are located at a second height in the thickness direction and are adjacent to the first resistance film portions in a first direction orthogonal to the thickness direction,
the method comprising:
forming, on a semiconductor layer, an insulating film including an insulating material;
forming, on the semiconductor layer, a protruded portion that includes the insulating material and includes an upper surface and a side surface, by selectively removing the insulating film;
forming a resistance film including a resistant material to cover both the protruded portion and a portion of the semiconductor layer surrounding the protruded portion; and
separating the first resistance film portion covering the upper surface of the protruded portion and the second resistance film portion covering the portion surrounding the protruded portion, by removing a portion of the resistance film covering the side surface of the protruded portion.
